# EUROPEAN PATENT SPECIFICATION

(11) **EP 1 753 839 B1**
(45) Date of publication and mention of the grant of the patent: **20.07.2011**
(21) Application number: 05743562.0
(22) Date of filing: 18.05.2005
(51) Int. Cl.: C09K 11/06, C07D 213/04, C07D 213/06, H05B 33/14

(54) **POLYMER LIGHT-EMITTING MATERIAL AND ORGANIC LIGHT EMITTING ELEMENT**
POLYMERES LICHTEMITTIERENDES MATERIAL UND ORGANISCHES LICHTEMITTIERENDES ELEMENT
MATERIAU POLYMERE ELECTROLUMINESCENT ET ELEMENT ORGANIQUE ELECTROLUMINESCENT

(30) Priority: 21.05.2004 JP 2004152332
(43) Date of publication of application: 21.02.2007
(73) Proprietor: Showa Denko K.K., Tokyo 105-8518 (JP)
(72) Inventor: TAKAHASHI, Yoshiaki, c/o Corporate R&D Center,, Chiba-shi, Chiba 267-0056, (JP); KATOH, Tsuyoshi, c/o Corporate R&D Center,, Chiba-shi, Chiba 267-0056, (JP); SAKO, Kanjiro, c/o Corporate R&D Center,, Chiba-shi, Chiba 267-0056, (JP)
(74) Representative: Strehl Schübel-Hopf & Partner
(86) International application number: PCT/JP2005/009486
(87) International publication number: WO 2006/001150

(56) References cited:
- US-A1- 2003 186 080
- PATENT ABSTRACTS OF JAPAN vol. 2003, no. 11, 5 November 2003 (2003-11-05) & JP 2003 206320 A (SHOWA DENKO KK), 22 July 2003 (2003-07-22)

## Description

### CROSS-REFERENCE TO RELATED APPLICATION

This is an application filed pursuant to 35 U.S.C. Section 111 (a) with claiming the benefit of U.S. provisional application Serial No. 60/574, 947 filed May 28, 2004 under the provision of 35 U.S.C. 111(b), pursuant to 35 U.S.C. Section 119(e)(1).

### TECHNICAL FIELD

The present invention relates to an organic light emitting element, which emits light by electric energy, usable for flat display panels or backlights used therein, light source for illumination, electrophotography, light source for optical devices, indication board and the like, and a polymer light-emitting material used in the element.

### BACKGROUND ART

An organic light emitting element is an element which emits light by applying electric current to an organic thin layer present between electrodes, and since it not only enables high brightness at low energy consumption but also can rapidly respond to the applied voltage, its application to indicator device, light source for illumination or the like is expected. In 1987, C. W. Tang, et al. of Eastman Kodak Company first reported an organic light emitting element produced by laminating organic fluorescent compound molecules through a vacuum deposition method, which enabled high-brightness light emission (Appl. Phys. Lett., Vol. 51, Page 913, 1987), and since then, developments of materials and improvements in element structures have been rapidly proceeding, so that organic light-emitting elements have recently been put into practical use in displays of car audio systems and cellular phones, etc. In order to further widen the application of the organic light-emitting elements, it is necessary to develop materials which can increase the light emitting efficiency or the durability and enable application into large-area products and mass-production.

As an approach for increasing light-emitting efficiency, use of phosphorescent materials comprising organic heavy metal complex compound has been proposed. Light-emitting materials used in conventional organic light-emitting elements are fluorescernt materials, which emit light energy in transition process from the excited singlet state to the ground state. However, since the formation ratio of singlet excitons to triplet excitons is 1/3 in electroexcitation, the upper limit of the internal quantum efficiency in organic light emitting element using a fluorescent material is 25% (Monthly Display, additional volume of October issue "Organic EL Display", Page 58, 1998). Under the circumstances, M. A. Baldo, et al. found out that use of an iridium complex capable of emitting phosphorescence in the excited triplet state can achieve the external quantum efficiency of 7.5%, and this finding indicates that this external quantum efficiency corresponds to 37.5% as internal quantum efficiency in consideration that the light out-coupling efficiency is estimated as approximately 20%, which exceeds the conventional external quantum efficiency upper limit of 25% in a case of using a fluorescent material (Appl. Phys. Lett., Vol. 75, Page 4, 1999).

Meanwhile, although vacuum deposition method has been widely used to form organic film layers in organic light-emitting elements, the method is disadvantageous in that a vacuum apparatus is required and that the larger the area of the organic thin film to be formed is, the more difficult it is to form the film with a uniform thickness. Thus, the method is not necessarily suitable for mass production of large area panels. On the other hand, spin coating methods, ink-jet methods and printing methods, which have been developed as film-forming method through coating, enable film-formation under normal pressure and suitable for area enlargement and mass-production of organic light-emitting elements. Since these coating methods cannot be applied to film forming using a low molecular-weight compound which may cause phase separation or segregation, developments of polymer light-emitting materials which do not crystallize have been demanded.

Therefore, as a light-emitting material having a high light-emission efficiency and an excellent film-formability, development of a polymer material comprising an iridium complex structure in the main chain or a side chain is being proposed. For example, JP-A-2003-73480 and JP-A-2003-73479 disclose polymer materials each having an iridium complex bonded to the main chain and the side chain of polyarylene which is a π-conjugated polymer and organic light emitting elements using the materials. However, the phosphorescent energy of a π-conjugated polymer, i.e., the energy difference between the excited triplet state and the ground state is small in most cases, visible lights such as green light which require relatively high energy cannot be emitted by using π-conjugated polymer light-emitting material where an iridium complex is bonded, and moreover, the quantum yield of phosphorescence derived from π-conjugated polymer material is low. Therefore, use of such a phosphorescent material does not enable production of an organic light-emitting element having a high efficiency. Furthermore, solubility of π-conjugated polymer in organic solvent is low, which is problematic in that it is difficult to prepare a coating solution of the polymer required for production of an organic light-emitting element. Thus, development of a phosphorescent polymer material having a high solubility and high phosphorescent energy, where an iridium complex is bonded to a polyethylene main chain is being demanded.

As polymer material where an iridium complex is bonded to a polyethylene main chain, for example, JP-A-2003-119179 discloses a copolymer of a carrier transporting material and a phosphorescent iridium complex. In polymers like this, an iridium complex (tris(2-(2-pyridyl)phenyl)iridium) is bonded to the main chain through an oxycarbonyl group such as ester. Hetero atoms such as oxygen atom bonded to a ligand of the iridium complex have a great influence on light-emitting property of the iridium as compared with non-hetero atoms, and cause change in the phosphorescent energy and decrease in the quantum yield. Therefore, in order to enhance performance of an organic light-emitting element using polymer, development of a polymer material not including a hetero atom in a group bonding an iridium complex with the polymer main chain is needed.

As such a polymer, JP-A-2002-293830 discloses a polyvinylcarbazole partially substituted with an iridium complex, which is synthesized by reacting a precursor of an iridium complex with a polyvinylcarbazole whose carbazole side chain is partially substituted with a phenylpyridine to serve as a ligand of the iridium complex. However, in this synthetic method, since cyclometallation reaction with iridium of phenylpyridine as a polymer side chain cannot proceed efficiently and polymer crosslinking reaction by iridium occurs, reaction control is difficult, and therefore polymers thus obtained cannot always be said to have properties of light-emission efficiency and film formability for exhibiting satisfactory performances as a polymer having an expected structure. Accordingly, it is preferable that a polymer light-emitting material be produced by synthesis involving (co) polymerization of a polymerizable compound containing an iridium complex, however, no such polymer has been disclosed so far.

### DISCLOSURE OF THE INVENTION

As described above, conventional polymer light-emitting materials where a phosphorescent iridium complex is bonded to constitute the structure of the main chain or side chain involve problems that the phosphorescence quantum yield, solubility in solvents and film-formability are low. Accordingly, the light-emission efficiency of organic light-emitting elements produced by using such conventional materials is low and their brightness half-life with a constant-current supply is short. The present invention solves these problems to provide a phosphorescent polymer material having a high emission efficiency and good film formability, and the object of the present invention is to further enhance efficiency and prolong life of an organic light-emitting element by using the polymer material.

The present invention solves the above problems by using a polymer material obtained by polymerizing a polymerizable compound containing an iridium complex substituted with a polymerizable hydrocarbon group.

That is, the present invention relates to the following polymer material, organic light-emitting element, display device and area light source.
1. A polymer light-emitting material, which is obtained by (co) polymerizing one or more polymerizable compounds having a substituent in which a polymerizable double bond moiety represented by formula (2): 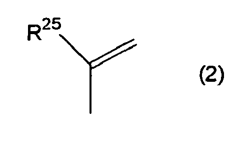 (wherein R²⁵ represents a hydrogen atom or a straight-chain alkyl group having 1 to 5 carbon atoms) is bonded to one of the carbon atoms of an aromatic ring,
   wherein at least one of the polymerizable compounds is an iridium complex represented by formula (1): 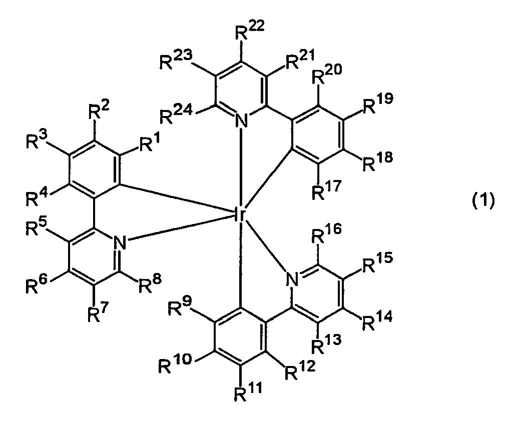 (wherein R¹ to R²⁴ each independently represents a hydrogen atom, a halogen atom, a cyano group, an alkyl group having 1 to 10 carbon atoms, an aryl group having 6 to 10 carbon atoms, an amino group which may be substituted by an alkyl group having 1 to 10 carbon atoms, an alkoxy group having 1 to 10 carbon atoms or a silyl group, with a proviso that one of R² to R⁷ is a polymerizable substituent selected from a polymerizable double bond moiety represented by formula (2), an aromatic ring group where a polymerizable double bond moiety represented by formula (2) is bonded to one of the carbon atoms of the ring and a hydrocarbon group which is substituted with the aromatic ring group having a polymerizable double bond moiety represented by formula (2) and does not contains a hetero atom).
2. The polymer light-emitting material as described in 1 above, wherein R¹, R⁴, R⁵, R⁸, R⁹, R¹², R¹³, R¹⁶, R¹⁷, R²⁰, R²¹ and R²⁴ in formula (1) are hydrogen atoms.
3. The polymer light-emitting material as described in 1 above, wherein the polymerizable substituent is a vinyl group or a group represented by formula (3) 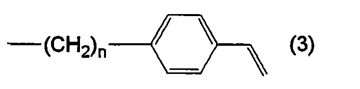 (wherein n represents 0 or an integer of 1 to 10).
4. The polymer light-emitting material as described in any one of 1 to 3 above, which is a copolymer of at least one carrier-transporting compound and a polymerizable iridium complex represented by formula(1).
5. The polymer light-emitting material as described in 4 above, wherein the carrier-transporting compound is a hole-transporting compound.
6. The polymer light-emitting material as described in any one of 1 to 5 above, which is obtained by copolymerizing two or more kinds of polymerizable compounds containing a polymerizable compound represented by formula (4) and a polymerizable iridium complex represented by formula (1). 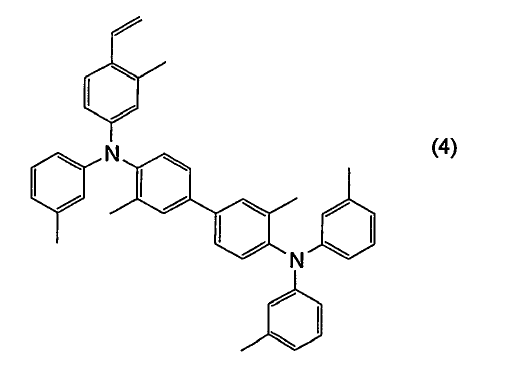
7. The polymer light-emitting material as described in 4 above, wherein the carrier-transporting compound is an electron-transporting compound.
8. The polymer light-emitting material as described in any one of 1 to 7 above, which is obtained by copolymerizing two or more kinds of polymerizable compounds containing a polymerizable compound represented by formula (5) and a polymerizable iridium complex represented by formula (1). 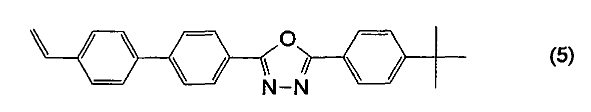
9. The polymer light-emitting material as described in 4 above, which is a copolymer of polymerizable compounds containing an iridium complex represented by formula (1), a hole-transporting compound and an electron-transporting compound.
10. The polymer light-emitting material as described in 9 above, which is obtained by copolymerizing three or more kinds of polymerizable compounds containing an iridium complex represented by formula (1), a hole-transporting compound represented by formula (4) and an electron-transporting compound represented by formula (5).
11. The polymer light-emitting material as described in 1 above, which is obtained by polymerizing a polymerizable iridium complex represented by formula (1).
12. An organic light-emitting element, comprising a pair of electrodes and one or multiple organic layers including a light-emitting layer using the polymer light-emitting material described in any one of 1 to 11 above between the electrodes.
13. An area light source using the organic light-emitting device described in 12 above.
14. An image display device using the organic light-emitting device described in 12 above.

Mode for carrying out the present invention is specifically described below.

The polymer light-emitting material can be obtained by (co)polymerizing at least one polymerizable compound containing an iridium complex represented by formula (1). 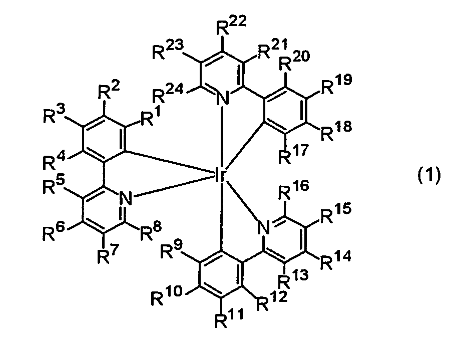 In the formula, R¹ to R²⁴ each independently represents a hydrogen atom, a halogen atom, a cyano group, an alkyl group having 1 to 10 carbon atoms, an aryl group having 6 to 10 carbon atoms, an amino group which may be substituted by an alkyl group having 1 to 10 carbon atoms, an alkoxy group having 1 to 10 carbon atoms or a silyl group, with a proviso that one of R² to R⁷ is a polymerizable substituent selected from a polymerizable double bond moiety represented by formula (2), an aromatic ring group where a polymerizable double bond moiety represented by formula (2) is bonded to one of the carbon atoms of the ring and a hydrocarbon group which is substituted with the aromatic ring group having a polymerizable double bond moiety represented by formula (2) and does not contains a hetero atom. 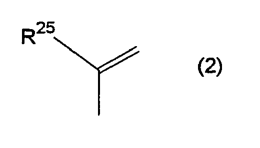 (In the formula, R²⁵ represents a hydrogen atom or a straight-chain alkyl group having 1 to 5 carbon atoms.)

It is preferred that the polymerizable double bond moiety represented by formula (2) is bonded to an aromatic ring such as a benzene ring, a naphthalene ring and a pyridine ring for the better polymerizability. The aromatic ring may be a phenylpyridine ring bonded to iridium. R²⁵ is preferably a linear alkyl group such as a methyl group, an ethyl group and a propyl group.

The polymerizable double bond moiety represented by formula (2) may be directly bonded to a phenylpyridine ring bonded to an iridium or maybe bonded to a phenylpyridine ring as a polymerizable substituent containing a polymerizable double bond moiety represented by formula (2).

Examples of the polymerizable substituent include polymerizable double bond moiety represented by formula (2), an aromatic ring group where a polymerizable double bond moiety represented by formula (2) is bonded to one of the carbon atoms of the ring and a hydrocarbon group substituted with such an aromatic ring group having a polymerizable double bond moiety represented by formula (2). It is preferable that no hetero atom be contained in the aromatic ring group nor the hydrocarbon group. Preferable examples of the aromatic ring group include phenyl group and naphthyl group, and preferable examples of the hydrocarbon group include alkyl group having 1 to 10 carbon atoms.

More preferred examples of the polymerizable substituent include a vinyl group and a group represented by formula (3) 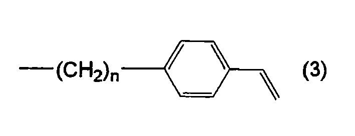 (wherein n represents 0 or an integer of 1 to 10).

When a polymerizable substituent contains a hetero atom, particularly when a phenylpyridine ring coordinated to an iridium is connected with the polymerizable substituent through the hetero atom, light-emission efficiency of thus produced polymer light-emitting material markedly decreases and life of an organic light-emitting element manufactured using the material is short.

Preferable examples of polymerizable substituents include those having a structure as represented by formula (E-1) to (E-11).

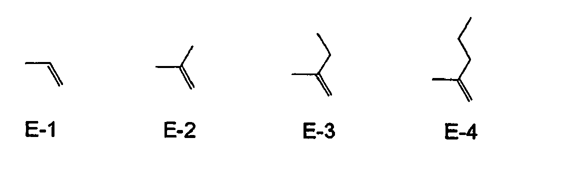

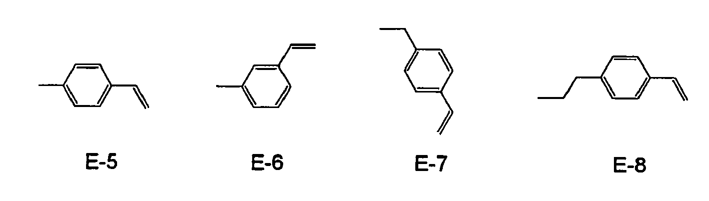

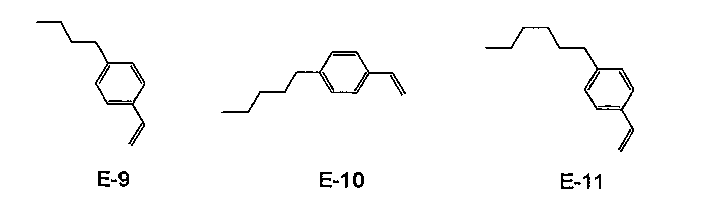

It is preferable that such a polymerizable substituent be bonded to a position of R² to R⁷ in formula (1), more preferably at R², R³, R⁶ or R⁷.

The substituents R¹ to R²⁴ in formula (1) have a great influence on the light-emission efficiency, light colors, emission life, emission intensity, solubility, glass transition temperature, primary structure, secondary structure and the like of the polymer light-emitting material. Among these substituents, examples of non-polymerizable substituents include a hydrogen atom, a halogen atom (such as a fluorine atom and a chlorine atom), a cyano group, an alkyl group having 1 to 10 carbon atoms (such as a methyl group, an ethyl group, a propyl group, an isopropyl group, a butyl group, an isobutyl group, a t-butyl group, an amyl group, a hexyl group, an octyl group and a decyl group), an aryl group having 6 to 10 carbon atoms (such as a phenyl group, a tolyl group, a xylyl group, mesityl group and naphthyl group), an amino group which may be substituted with an alkyl group having 1 to 10 carbon atoms (such as an amino group, a dimethylamino group, a diethylamino group and a dibutylamino group), an alkoxy group having 1 to 10 carbon atoms (such as a methoxy group, an ethoxy group, a propoxy group, an isopropoxy group, a butoxy group, an isobutoxy group, a t-butoxy group, a hexyloxy group, a 2-ethylhexyloxy group and a decyloxy group) and a silyl group (such as a trimethylsilyl group, triethylsilyl group and t-butyldimethylsilyl group). Preferred among them are a hydrogen atom, a fluorine atom, an alkyl group having 1 to 4 carbon atoms, a phenyl group, a tolyl group, a dimethylamino group and an alkoxy group having 1 to 4 carbon atoms, and particularly preferred are a hydrogen atom, a fluorine atom, a t-butyl group, a dimethylamino group and a methoxy group. Further, among the substituents, those adjacent to each other in one ligand may be bonded to each other at one or more sites to form a condense ring.

The polymer light-emitting material of the present invention may be obtained by polymerizing a polymerizable iridium complex represented by formula (1) or by copolymerizing a polymerizable compound having , as a polymerizable functional group, a polymerizable double bond moiety represented by formula (2) which is bonded to one of the carbon atoms of an aromatic ring with a polymerizable iridium complex represented by formula (1). Also, such a copolymer may be prepared by using two or more kinds of polymerizable iridium complex represented by formula (1) . In a case of obtaining copolymer by using two or more polymerizable compounds each having a substituent represented by formula (2), R²⁵ in each of the compound may be different or the same.

It is preferable that a polymerizable compound other than an iridium complex be a compound having a carrier-transporting property. Representative Examples thereof include hole-transporting compounds as represented by formulae (E-12) to (E-17) and electron-transporting compounds as represented by formulae (E-18) to (E-25) . Although the polymerizable substituent has the structure of (E-1) in these representative examples, the structure may be a structure as shown by any one of (E-2) to (E-11).

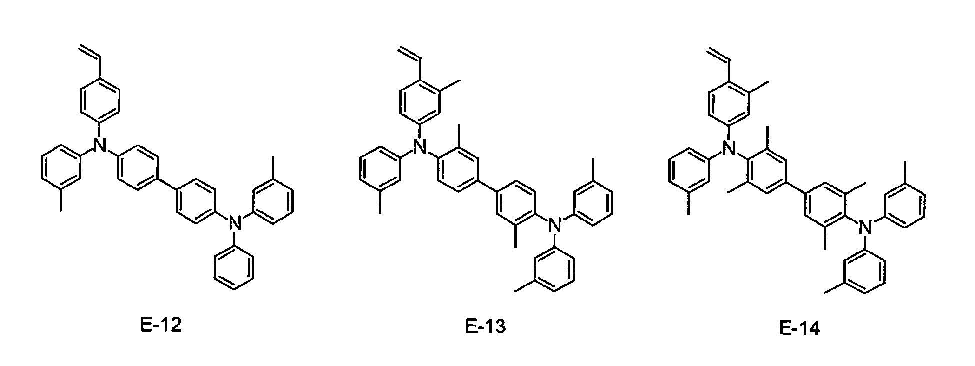

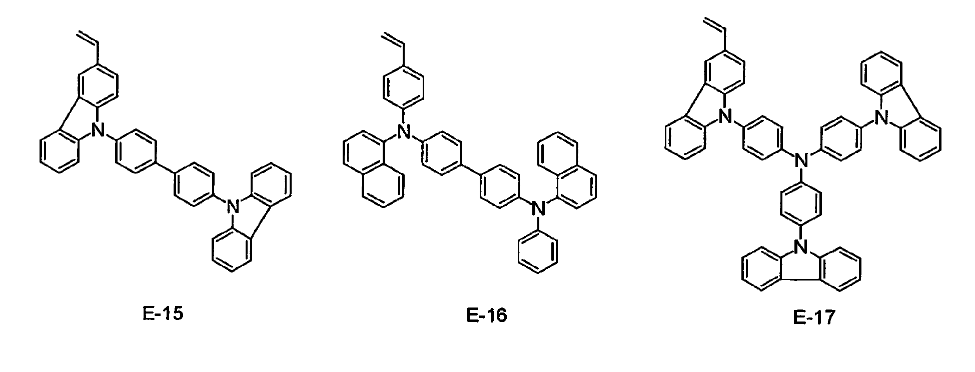

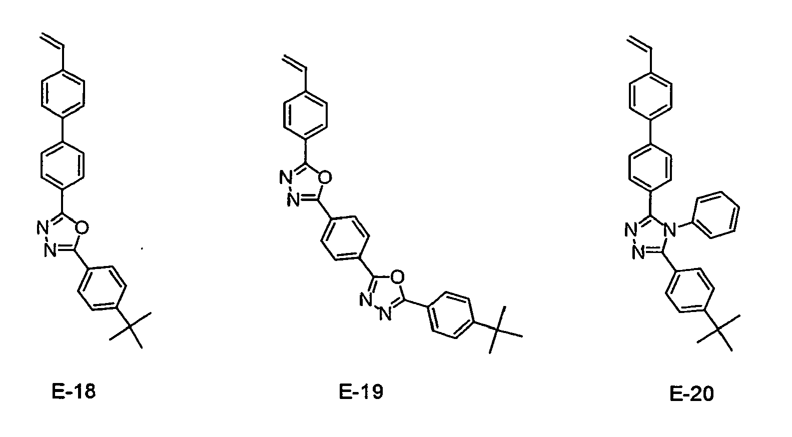

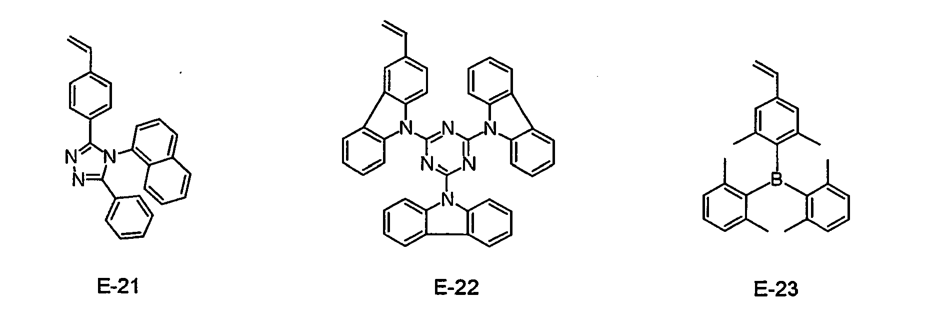

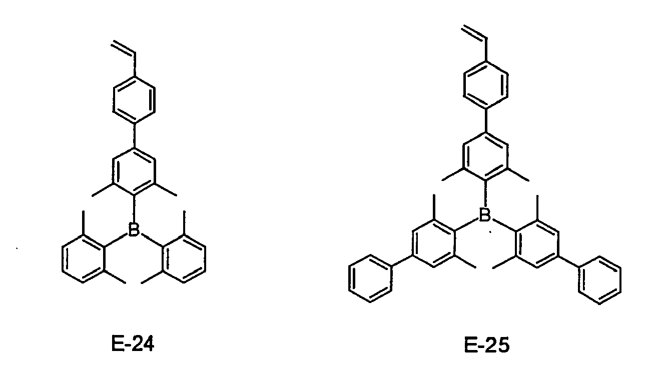

The polymerization method in the present invention may be any one of radical polymerization, cationic polymerization, anionic polymerization and addition polymerization, and preferred method is radical polymerization. With respect to the molecular weight of the polymer, the weight average molecular weight is preferably 1,000 to 2, 000, 000, more preferably 5, 000 to 1, 000, 000. The molecular weight value mentioned herein is a value measured in terms of polystyrene by using GPC (Gel Permeation Chromatography).

With respect to the monomer arrangement, the copolymer of the present invention may be any one of random copolymer, block copolymer and alternate copolymer. When in a copolymer of an iridium complex and a carrier transporting compound, the repeating number of a structural unit of the iridium complex is m and the repeating number of a structural unit of the carrier-transporting compound is n (m and n each is an integer of 1 or more), the ratio of the number of the repeated structural units of the iridium complex to the total number of all the repeated units, i. e, m/ (m+n), is preferably from 0.001 to 0.5, more preferably from 0.001 to 0.2.

The polymerizable substituent represented by formula (2) can be easily obtained by dehydrating a product of reaction between aryl magnesium bromide and a methylketone compound according to Scheme 1. R²⁵ is not particularly limited, however, preferably R²⁵ is a hydrogen atom with little steric hindrance in a polymerization reaction or a linear alkyl group having 1 to 5 carbon atoms, particularly preferred are a hydrogen atom and a methyl group.

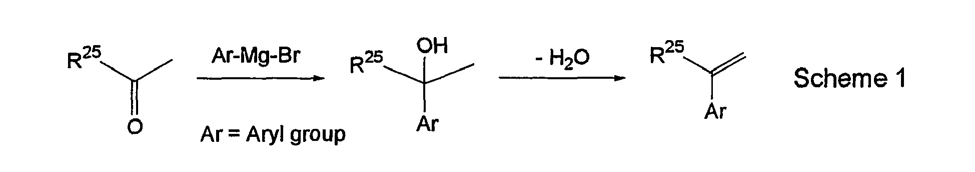

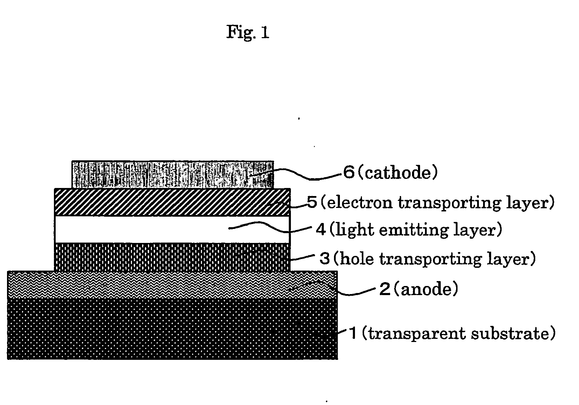

Fig. 1 is a cross-sectional view showing an example of the structure of the organic light emitting element according to the present invention. The structure is such that a hole transporting layer 3, a light-emitting layer 4, and an electron transporting layer 5 are formed in this order between an anode 2 and a cathode 6 disposed on a transparent substrate 1. The structure of the organic light emitting element of the present invention is not limited to the example of Fig. 1, and may have, between an anode 2 and a cathode 6, either one of the following layer combinations 1) and 2) :
1) a hole transporting layer/a light-emitting layer and
2) a light-emitting layer/an electron transporting layer;
   or any single layer of the following 3) to 6):
3) a layer containing a hole transporting material, a light-emitting material and an electron transporting material,
4) a layer containing a hole transporting material and a light-emitting material,
5) a layer containing a light-emitting material and an electron transporting material and
6) a layer containing only a light-emitting material.
Further, the organic light emitting device may have two or more light-emitting layers although the structure shown in Fig. 1 has one light-emitting layer.

In the organic light emitting element of the present invention, the light-emitting layer is composed of the polymer light-emitting material of the present invention. Further, for the purpose of compensating the carrier transporting properties of the light-emitting layer, a hole transporting material or an electron transporting material may be contained therein. As such a carrier-transporting material, not only a low-molecular weight compound but also a polymer compound may be employed.

Examples of hole transporting material used for constituting the hole-transporting layer or for mixing into the light-emitting layer include low molecular weight triphenylamine derivatives such as TPD (N,N'-dimethyl N,N'-(3-methylphenyl)-1,1-biphenyl-4,4'diamine), α-NPD (4,4'-bis[N-(1-naphthyl)-N-phenylamino]biphenyl), and m-MTDATA (4,4',4" -tris(3-methylphenylphenylamino)triphenylamine) and known hole transporting materials such as polyvinylcarbazoles and those obtained by incorporating a polymerizable functional group into said triphenylamine derivative and polymerizing it, such as polymer compound having a triphenylamine structure disclosed in JP-A-8-157575. Moreover, fluorescent polymer materials such as poly(paraphenylenevinylene) and polydialkylfluorene can also be used. These hole transporting materials may be used singly or two or more of them may be used in combination or in laminates. The thickness of the hole transporting layer is preferably 1 nm to 5 µm, more preferably 5 nm to 1 µm, further preferably 10 nm to 500 nm, though it depends on the conductivity of the hole transporting layer and is not generally restricted.

Examples of the electron transporting materials used for forming the electron transporting layer or for mixing into the light-emitting layer include low-molecular weight materials such as quinolinol derivative metal complexes (such as Al(q)₃ (aluminum tris(quinolinolate)), oxadiazole derivatives, triazole derivatives, imidazole derivatives, triazine derivatives and triarylborane derivatives. Further, the electron transporting material may be a polymer produced by introducing a polymerizable functional group into the above-mentioned low molecular weight electron transporting compound, such as poly (PBD) disclosed in JP-A-10-1665. These electron transporting materials may be used singly, or mixed or layered with other electron transporting materials. The thickness of the electron transporting layer is preferably 1 nm to 5 µm, more preferably 5 nm to 1 µm, further preferably 10 nm to 500 nm, though it depends on the conductivity of the hole transporting layer and is not generally restricted.

Each of the light emitting material, the hole transporting material and the electron transporting material may be formed into each layer, singly or in mixture with other material having different functions. Also, each layer may be formed by using a polymer material as a binder. Examples of the polymer materials usable for the binder include polymethyl methacrylates, polycarbonates, polyesters, polysulfones and polyphenylene oxides.

For the purpose of efficiently recombining holes with electrons in the light-emitting layer, a hole blocking layer may be disposed on the cathode side of the light-emitting layer in order that holes can be prevented from passing through the light-emitting layer. Examples of materials for the hole blocking layer include known materials such as triazole derivatives, oxadiazole derivatives and phenanthroline derivatives.

The method for forming a film for each of the light-emitting layer, the hole transporting layer and the electron transporting layer may be a resistance heating deposition method, an electron beam deposition method, a sputtering method, an ink-jet method, a spin coating method, a printing method, a spray method, a dispenser method, etc. In case of using low molecular weight compounds, dominantly employed are resistance heating deposition method and the electron beam deposition method, and in case of using polymer materials, dominantly employed are ink-jet method, the spin coating method and printing method.

Examples of materials usable for the anode of the organic light emitting element of the present invention include a known transparent conductive material such as ITO (indium tin oxide), tin oxide, zinc oxide, and conductive polymers such as polythiophenes, polypyrroles and polyanilines. The electrode comprising the transparent conductive material preferably has a surface resistance of 1 to 50 Ω/square. Such a material may be formed into a film by an electron beam deposition method, a sputtering method, a chemical reaction method, a coating method, etc. The anode preferably has a thickness of 50 to 300 nm.

An anode buffer layer may be disposed between the anode and the hole transporting layer or an organic layer laminated on the anode in order to alleviate the injection barrier for the holes. Known materials such as copper phthalocyanine, a mixture of polyethylene dioxythiophene (PEDOT) and polystyrene sulfonate (PPS), etc. can be used for the buffer layer.

Examples of materials usable for the cathode of the organic light emitting element of the present invention include known materials, i.e., alkaline metals such as Li, Na, K and Cs, alkaline earth metals such as Mg, Ca and Ba, Al, MgAg alloy and alloys of Al and an alkali metal such as AlLi and AlCa. The cathode can be formed from the material by a resistance heating deposition method, an electron beam deposition method, a sputtering method, an ion plating method, etc. The thickness of the cathode is preferably 10 nm to 1 µm, more preferably 50 to 500 nm. However, in a case where a metal having a high activity such as an alkali metal and an alkali earth metal is used as the cathode, it is preferable that the thickness of the cathode be 0.1 to 100 nm, more preferably 0.5 to 50 nm. Also, in this case, for the purpose of protecting the cathode metal, an additional layer using a metal which is stable to the air is laminated on the cathode. For this purpose, a metal such as Al, Ag, Au, Pt, Cu, Ni and Cr is used. The thickness of the layer is preferably 10 nm to 1 µm, more preferably 50 to 500 nm.

An insulating layer having a thickness of 0.1 to 10 nm may be disposed between the cathode and the electron transporting layer or an organic layer laminated adjacent to the cathode in order to enhance the injection efficiency of electrons. Known cathode materials such as lithium fluoride, magnesium fluoride, magnesium oxide and alumina can be used for the insulating layer.

In the organic light emitting element of the present invention, the substrate may be an insulating substrate transparent for the emission wavelength of the light emitting material. Known materials, for example, glasses and transparent plastics including PET (polyethylene terephthalate), and polycarbonate can be used for the substrate.

By using the organic light-emitting element of the present invention, pixels can be formed in matrix or in segment by known methods. Alternatively, the organic light-emitting element can be used for backlights instead of pixels.

### BRIEF DESCRIPTION OF DRAWINGS

Fig.1 shows a cross-sectional view of one embodiment of an organic light emitting element according to the present invention.

### BEST MODE FOR CARRYING OUT THE INVENTION

The present invention will be explained in more detail below referring to typical examples. The examples are considered in all respects to be illustrative, and the present invention is not restricted thereto.

Measuring apparatuses used in the Examples below are as follows. In the Examples, commercially available products (reagent grade) were used for reagents without purification unless otherwise indicated specifically.
1) ¹H-NMR and ¹³C-NMR
   JNM EX270 manufactured by JEOL Ltd.
   270 MHz
   Solvent: Chloroform-d
2) GPC measurement (molecular weight measurement)
   Column: Shodex KF-G + KF804L + KF802 + KF801
   Eluent: Tetrahydrofuran (THF)
   Temperature: 40°C
   Detector: RI (Shodex RI-71)
3) Elemental analysis apparatus
   Type CHNS-932 manufactured by LECO Corporation
4) ICP elemental analysis
   ICPS 8000 manufactured by Shimadzu Corporation
5) Mass spectrometry (FAB-MS)
   Automass II manufactured by JEOL Ltd.

### Example 1 (a) to (h) and Comparative Example 1 (a) to (h):

### Synthesis of polymerizable iridium complex Example 1 (a): Synthesis of polymerizable compound (1-1(a))

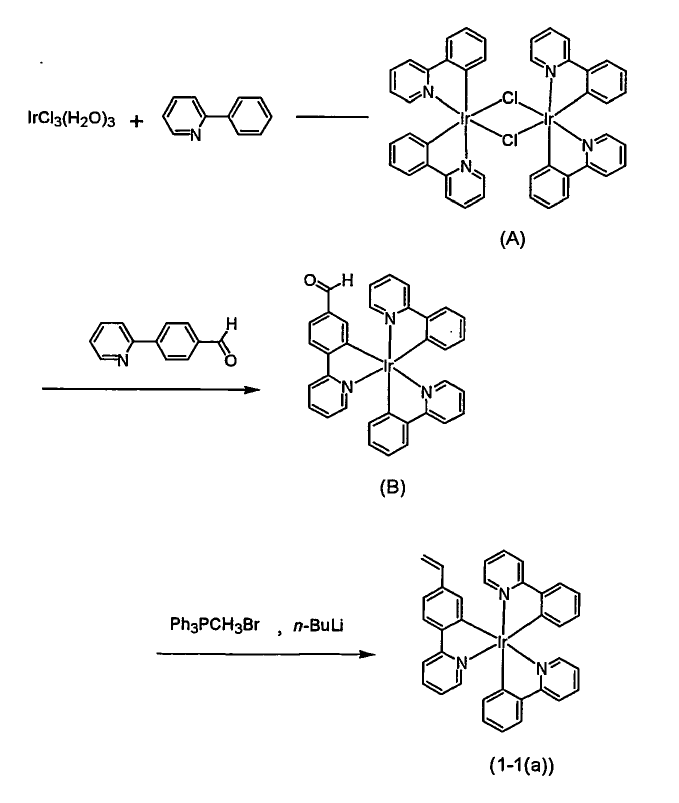

150 mL of 2-ethoxyethanol, 50 mL of water and 9.0 g (58 mmol) of 2-phenylpyridine were added to 10.0 g (28 mmol) of iridium chloride (III) trihydrate and the resultant mixture was heated under reflux for 12 hours under a nitrogen atmosphere. The obtained reaction solution was left standing until the temperature was cooled to room temperature and the generated precipitate was separated using a glass filter. Then the precipitate was washed with methanol and dried under reduced pressure to thereby obtain 13.5 g (13 mmol) of iridium complex (A) with a yield of 89 %.

To a mixture of 5. 00 g (4.7 mmol) of the obtained iridium complex (A) and 1.71 g (9.3 mmol) of 4-(2-pyridyl) benzaldehyde, 500 mL of toluene was added and the resultant mixture was stirred at room temperature for 5 minutes. Then, to this was added 2.40 g (9.3 mmol) of silver trifluoromethanesulfonate and heated under reflux for 3 hours under a nitrogen atmosphere. The obtained reaction solution was left standing until the temperature was cooled to room temperature and then filtered through Celite. After the solvent was distilled off under a reduced pressure, the residue was purified by a silica gel column chromatography using a eluent (chloroform /ethyl acetate = 19/1), and recrystallized from a mixed solution of dichloromethane/methanol to obtain 0.95 g (1.4 mmol) of iridium complex (B) with a yield of 15 %.

Next, 199 mg (0.56 mmol) of methyl triphenyl phosphonium bromide was dissolved in 10 mL of THF, and 0.40 mL (0.64 mmol) of a 1. 6 M hexane solution was added thereto at 0°C. After stirring the mixture at 0°C for 30 minutes, 248 mg (0.36 mmol) of iridium complex (B) was added to the mixture and the resultant mixture was further stirred at room temperature for 2 hours. To the obtained reaction solution was added dilute hydrochloric acid and the organic product was extracted with chloroform. The organic layer was dried over magnesium sulfate and the solvent was distilled off under a reduced pressure. The residue was purified by a silica gel column chromatography using a eluent (chloroform / hexane = 2/1) and recrystallized from a mixed solution of dichloromethane/methanol to obtain 100 mg (0.15 mmol) of polymerizable compound 1-1(a) with a yield of 50 %.
¹H NMR: 7.79 (m, 3 H), 7.46 (m, 9 H), 6.90 (m, 11 H), 6.55 (dd, 1 H), 5.44 (d, 1 H), 5.00 (d, 1 H). FAB-MS: 681 (M⁺). Elementary analysis Calcd for C₃₅H₂₆IrN₃: C, 61.75; H, 3.85; N, 6.17. Found: C, 61.91; H, 3.55; N, 6.02.

### Comparative Example 1 (a) : Synthesis of comparative polymerizable compound (1-2(a))

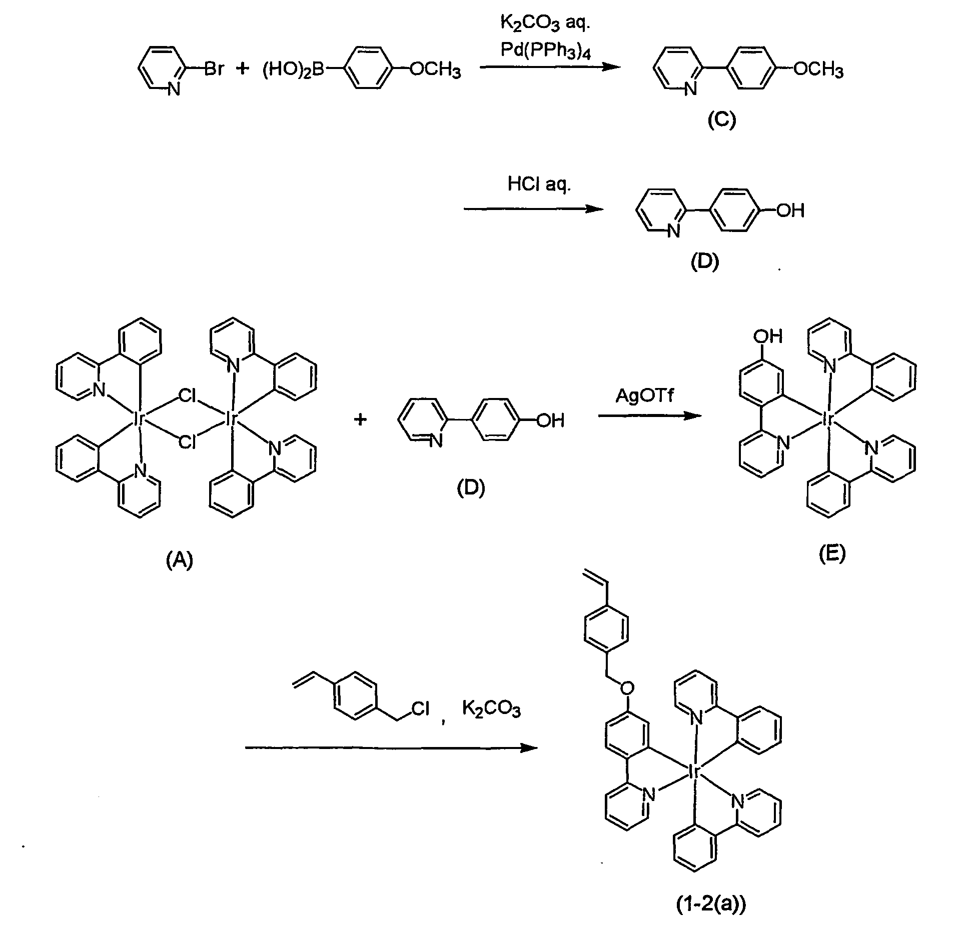

10.0 g (66 mmol) of 4-methoxyphenylboronic acid was dissolved in 50 mL of 1,2-dimethoxyethane, and 50 mL of a aqueous solution of 10.4 g (66 mmol) of 2-bromopyridine, 0.75 g (0.65 mmol) of tetrakis (triphenylphosphine) palladium and 25 g (180 mmol) of potassium carbonate was added thereto. Then, the mixture was heated under reflux for 3 hours under a nitrogen atmosphere. The obtained reaction solution was left standing until the temperature was cooled to room temperature. To this was added 100 mL of water and 100 mL of ethyl acetate and the mixture was shaken. The organic layer was dried over magnesium sulfate and then the solvent was distilled off under a reduced pressure. The residue was purified by a silica gel column chromatography using a eluent (chloroform /ethyl acetate = 19/1) to obtain 10.3 g (56 mmol) of compound (C) with a yield of 84 %.

8.5 g (46 mmol) of the obtained compound (C) was dissolved in concentrated hydrochloric acid and stirred in a sealed vessel at 130°C for 4 hours. The obtained reaction solution was neutralized with an aqueous solution of sodium hydrogen carbonate while cooling in an ice bath and the organic product was extracted with chloroform. The chloroform solution was concentrated and hexane was added thereto, and then by cooling it to -20 °C, 6.8 g (40 mmol) of crystal compound (D) was obtained with a yield of 86 %.

To a mixture of 500 mg (2.9 mmol) of the obtained compound (D), 1.50 g (1.3 mmol) of iridium complex (A) synthesized in Example 1(a) and 680 mg (2.65 mmol) of silver trifluoromethanesulfonate, 500 mL of toluene was added, and the resultant mixture was heated under reflux for 3 hours under a nitrogen atmosphere. The obtained reaction solution was left standing until the temperature was cooled to room temperature and then filtered through Celite. After the solvent was distilled off under a reduced pressure, the residue was purified by a silica gel column chromatography using a eluent (chloroform /ethyl acetate = 9/1) and recrystallized from a mixed solution of dichloromethane/methanol to obtain 610 mg (0.91 mmol) of iridium complex (E) with a yield of 35 %.

To a mixture of 500 mg (0. 75 mmol) of the obtained iridium complex (E) and 300 mg (2.2 mmol) of potassium carbonate, 100 mL of acetone was added, and 300 mg (2.0 mmol) of 4-vinylbenzyl chloride was further added thereto. The mixture was heated under reflux for 24 hours under a nitrogen atmosphere. The obtained reaction mixture was filtered by glass filter and then the filtrate was concentrated under a reduced pressure. The residue was purified by a silica gel column chromatography using a eluent (chloroform /ethyl acetate = 19/1) and recrystallized from a mixed solution of dichloromethane/methanol to obtain 390 mg (0.50 mmol) of polymerizable compound 1-2 (a) with a yield of 66 %.
¹H NMR: 7.80 (m, 3 H), 7.64 (m, 11 H), 7.20 (d, 2 H), 6.95 (m, 11 H), 6.59 (dd, 1 H), 5.40 (d, 1 H), 4.90 (d, 1 H), 4.51 (s, 2 H). FAB-MS: 787 (M⁺) . Elementary analysis Calcd for C₄₂H₄₃IrN₃O: C, 64.10; H, 4.10; N, 5.34. Found: C, 64.38; H, 3.96; N, 5.29.

### Example 1 (b): Synthesis of polymerizable compound (1-1(b))

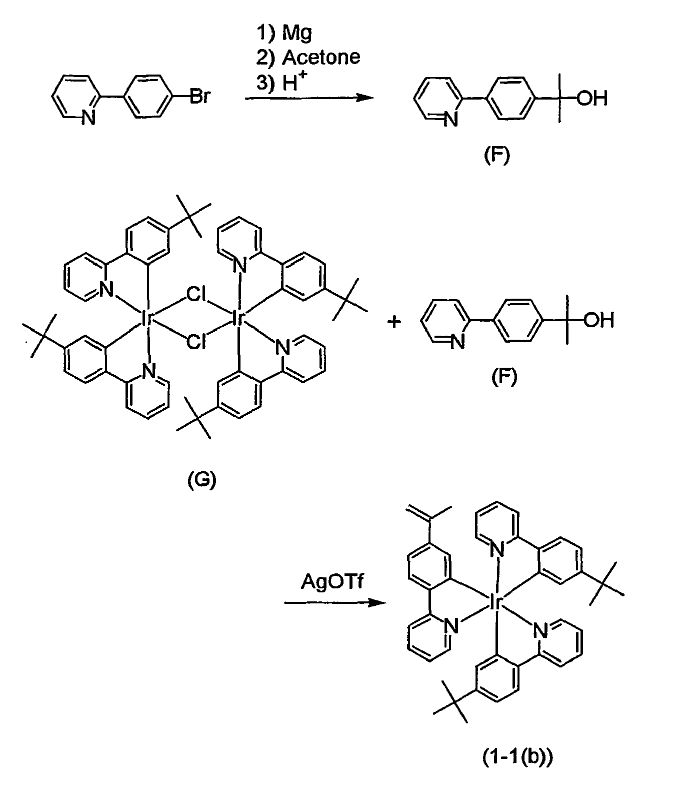

480 mg (20 mmol) of magnesium was weighed and charged into a reaction vessel filled with nitrogen atmosphere, and 10 mL of THF was added thereto. 40 mL of THF solution of 4.0 g (17 mmol) of 2- (4-bromophenyl) pyridine synthesized in the same manner as synthesis of compound (C) except for using 4-bromophenylboronic acid instead of 4-methoxyphenylboronic acid was added dropwise to the mixture over 1 hour and subsequently, the solution was further stirred for 1 hour at the room temperature. Then 20 mL of THF solution of 3.0 g (52 mmol) of acetone was added dropwise thereto while cooling in an ice bath. After stirring for 1 hour at the room temperature, 500 mL of water was added to the obtained reaction solution. Then, the organic product was extracted with ethyl acetate and washed with water and saturated saline and dried over anhydrous sodium sulfate. The solution was concentrated under a reduced pressure and the residue was purified by a silica gel column chromatography using a eluent (chloroform /ethyl acetate = 1/1) to obtain 2.1 g (9.8 mmol) of compound(F) with a yield of 58 %.

Then, to a mixture of 500 mg (0.30 mmol) of iridium complex (G), synthesized in the same manner as synthesis of iridium complex (A) except for using 2-(4-tert-buthylphenyl) pyridine (synthesized in the same manner as synthesis of compound (C) except for using 4-tert-buthylphenylboronic acid in place of 4-methoxyphenylboronic acid) in place of 2-phenyl pyridine, 150 mg (0.70mmol) of obtained compound (F) and 170 mg (0.66 mmol) of silver trifluoromethanesulfonate, 50 mL of toluene was added and the resultant mixture was heated under reflux for 3 hours under a nitrogen atmosphere. The obtained reaction liquid was left standing until the temperature was cooled to room temperature and then filtered through Celite. After the solvent was distilled off under a reduced pressure, the residue was purified by a silica gel column chromatography using a eluent of a chloroform and recrystallized from a mixed solution of dichloromethane/methanol to obtain 220 mg (0.27 mmol) of polymerizable compound 1-1 (b) with a yield of 45 %.
¹H NMR: 7.80 (m, 3 H), 7.55 (m, 9 H), 6.90 (m, 9 H), 5.17 (s, 1 H), 4.86 (s, 1 H), 1.91 (s, 3 H), 1.10 (s, 18 H). FAB-MS: 807 (M⁺). Elementary analysis Calcd for C₄₄H₄₄IrN₃: C, 65.48; H, 5.50; N, 5.21. Found: C, 65.87; H, 5.41; N, 5.06.

### Comparative Example 1 (b) : Synthesis of comparative poymerizable compound (1-2(b))

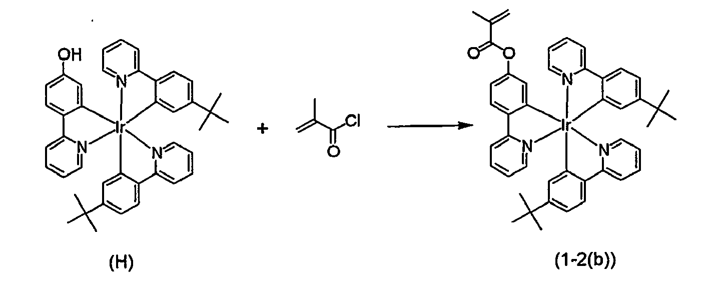

500 mg (0.64 mmol) of iridium complex (H), synthesized in the same manner as synthesis of iridium complex (E) except for using iridium complex (G) instead of iridium complex (A), was dissolved in 30 mL of dichloromethane. To this was added dropwise 5 mL of dichloromethane solution of 80 mg (0.77 mmol) of methacryloyl chloride and the resultant mixture was stirred for 1 hour at the room temperature. After the solvent was distilled off under a reduced pressure, the residue was purified by a silica gel column chromatography using a eluent of a chloroform and recrystallized from a mixed solution of dichloromethane/methanol to obtain 460 mg (0.54 mmol) of polymerizable compound 1-2(b) with a yield of 84 %.
¹H NMR: 7.85 (m, 3 H), 7.52 (m, 9 H), 7.01 (m, 9 H), 6.04 (s, 1 H), 5.51 (s, 1 H), 1.87 (s, 3 H), 1.10 (s, 9 H), 1.06 (s, 9 H). FAB-MS: 851 (M⁺). Elementary analysis Calcd for C₄₅H₄₄IrN₃O₂: C, 63.51; H, 5.21; N, 4.94. Found: C, 63.67; H, 5.17; N, 4.88.

### Example 1 (c): Synthesis of polymerizable compound (1-1(c))

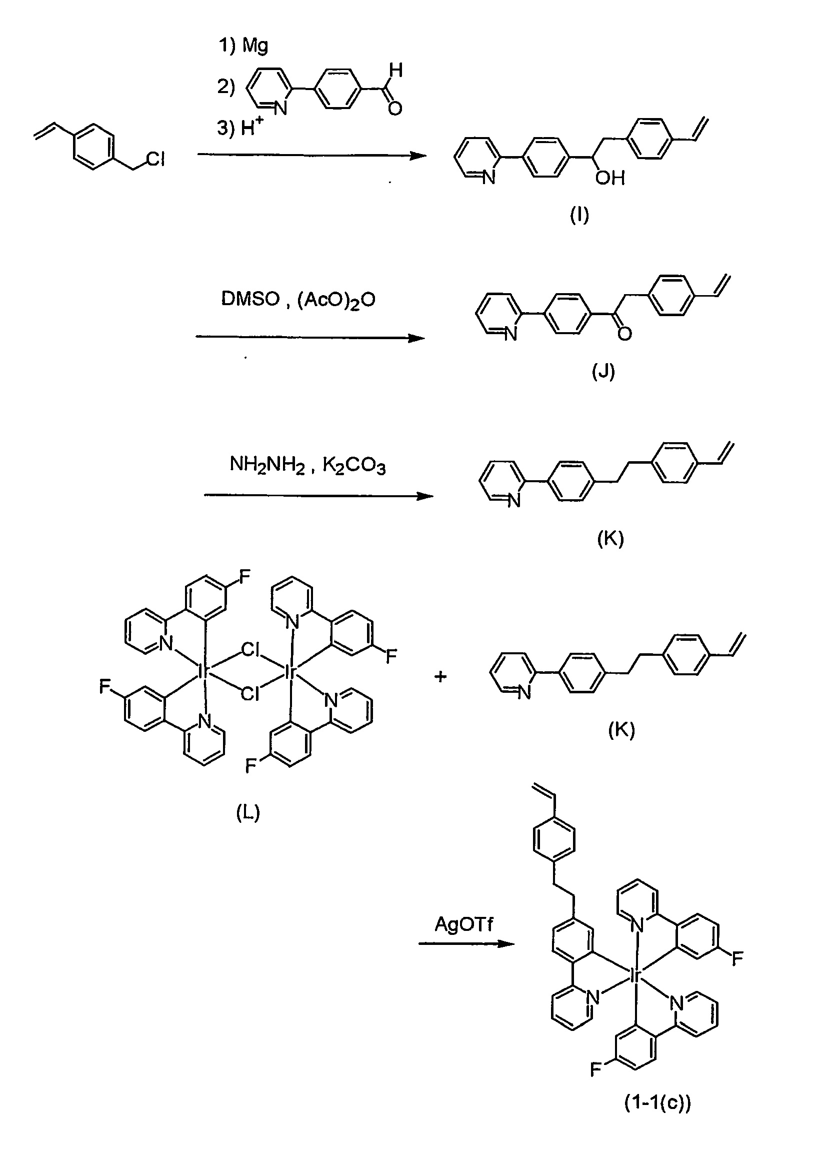

1.42 g (58 mmol) of magnesium was weighed and charged into a reaction vessel filled with nitrogen atmosphere, 50 mL of diethyl ether was added thereto. To this was added dropewise 100 mL of diethyl ether solution of 8.92 g (58 mmol) of 4-vinylbenzyl chloride over 2 hours. After dropping, the solution was further stirred for 1 hour at the room temperature and then 100 mL of diethyl ether solution of 10.1 g (55 mmol) of 4-(2-pyridyl)benzaldehyde was added dropwise thereto while cooling in an ice bath. After stirring for 1 hour at the room temperature, 500 mL water was added to the obtained reaction solution. Then, the organic layer was washed with water and saturated saline and dried over magnesium sulfate. The solvent was distilled off under a reduced pressure, and the residue was purified by a silica gel column chromatography using a eluent (chloroform/ethyl acetate = 2/1) to obtain 12.5 g (41 mmol) of compound (I) with a yield of 75 %.

Then, to 1.49 g (4.9 mmol) of obtained compound (I), 30 mL of dimethylsulfoxide and 20 mL of acetic anhydride were added and dissolved, and the resultant mixture was stirred for 12 hours at the room temperature. To the obtained reaction solution was added aqueous ammonia at 0 °C and then the generated precipitate was washed and dried under reduced pressure. The obtained solid was recrystallized from a mixed solution of dichloromethane/methanol to thereby obtain 1.33 g (4.4 mmol) of compound (J) with a yield of 91 %.

To a mixture of 7.0 g (23 mmol) of obtained compound (J) and 30.3 g (220 mmol) of potassium carbonate were added 700 mL of diethylene glycol and 11.4 g (230 mmol) of hydrazine monohydrate in this order and the solution was heated and stirred for 2.5 hours at 120 °C. After the solution was heated at 200 °C and the distillate was removed, the solution was left standing until the temperature was cooled to room temperature. To the obtained reaction mixture was added water and then the generated precipitate was washed and dried under reduced pressure. The solid was dissolved in chloroform and the solution was passed through a silica gel layer using a mixed solution (chloroform /ethyl acetate = 1/1). The obtained solution was concentrated to dryness under reduced pressure and recrystallization of the residue from hexane afforded 4.5 g (16 mmol) of compound (K) with a yield of 68 %.

Then, to a mixture of 500 mg (0.44 mmol) of iridium complex (L), synthesized in the same manner as synthesis of iridium complex (A) except for using 2-(4-fluorophenyl)pyridine (synthesized in the same manner as synthesis of compound (C) except for using 4-fluorophenylboronic acid in place of 4-methoxyphenylboronic acid) in place of 2-phenyl pyridine, 300 mg (1.05mmol)) of obtained compound (K) and 250 mg (0.97 mmol) of silver trifluoromethanesulfonate, 50 mL of toluene was added and the resultant mixture was heated under reflux for 3 hours under a nitrogen atmosphere. The obtained reaction solution was left standing until the temperature was cooled to room temperature and then filtered through Celite. After the solvent was distilled off under a reduced pressure, the residue was purified by a silica gel column chromatography using a eluent of chloroform / hexane = 2/1 and recrystallized from a mixed solution of dichloromethane/methanol to obtain 80 mg (0.097 mmol) of polymerizable compound 1-1 (c) with a yield of 11 %.
¹H NMR: 7.85 (m, 3 H), 7.58 (m, 9 H), 7.22 (m, 3 H), 7.0-6.6 (m, 11 H), 5.67 (d, 1 H), 5.16 (d, 1 H), 2.71 (m, 4 H). FAB-MS: 823 (M⁺). Elementary analysis Calcd for C₄₃H₃₄F₂IrN₃: C, 62.76; H, 4.16; N, 5.11. Found: C, 63.02; H, 4.09; N, 4.87.

### Comparative Example 1 (c) : Synthesis of comparative polymerizable compound (1-2(c))

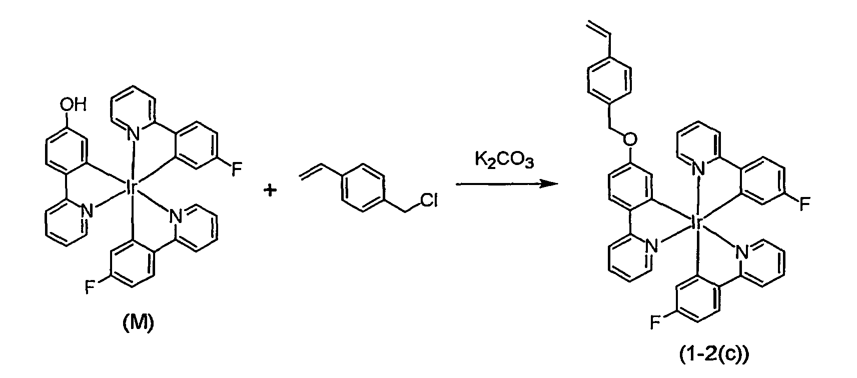

To a mixture of 300 mg (0.42 mmol) of iridium complex (M), synthesized in the same manner as synthesis of iridium complex (E) except for using iridium complex (L) instead of iridium complex (A), and 300 mg (2.2 mmol) of potassium carbonate, 100 mL of acetone was added and further, 300 mg (2. 0 mmol) of 4-vinylbenzyl chloride was added thereto. The mixture was heated under reflux for 24 hours under a nitrogen atmosphere. After the obtained reaction mixture was filtered by glass filter, the filtrate was concentrated under a reduced pressure. The residue was purified by a silica gel column chromatography using a eluent of chloroform and recrystallized from a mixed solution of dichloromethane/methanol to obtain 290 mg (0.37 mmol) of comparative polymerizable compound 1-2(c) with a yield of 88 %.
¹H NMR: 7.83 (m, 3 H), 7.59 (m, 11 H), 7.22 (d, 2 H), 6.96 (m, 9 H), 6.58 (dd, 1H), 5.44 (d, 1 H), 4.87 (d, 1 H), 4.60 (s, 2 H). FAB-MS: 825 (M⁺) . Elementary analysis Calcd for C₄₂H₃₂F₂IrN₃O: C, 61.15; H, 3.91; N, 5.09. Found: C, 61.00; H, 3.97; N, 5.44.

### Example 1 (d): Synthesis of polymerizable compound (1-1(d))

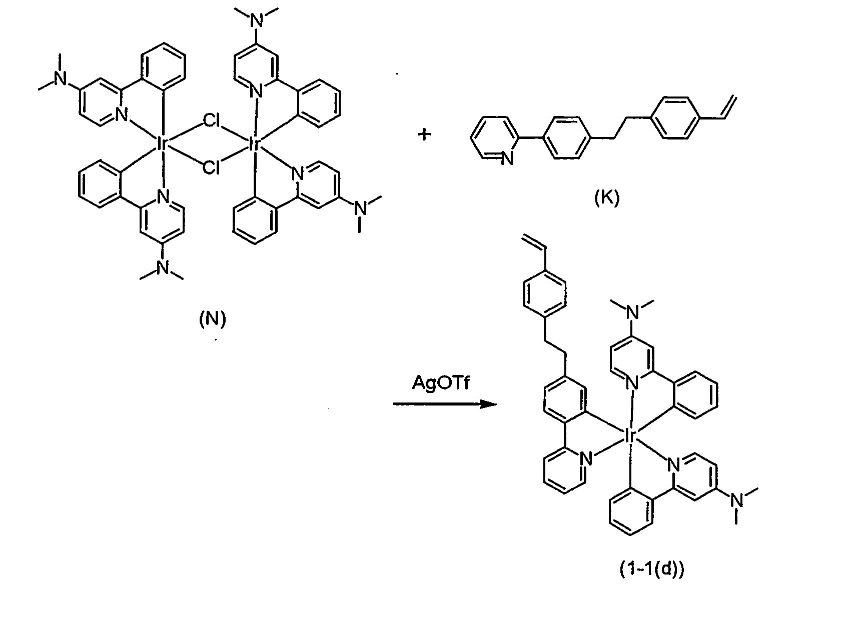

To a mixture of 500 mg (0.40 mmol) of iridium complex (N), synthesized in the same manner as synthesis of iridium complex (A) except for using 4-(dimethylamino)-2-phenylpyridine (synthesized in the same manner as synthesis of compound (C) except for using phenylboronic acid in place of 4-methoxyphenylboronic acid and using 2-bromo-4- (dimethyl) pyridine in place of 2-bromopyridine) in place of 2-phenyl pyridine, 170 mg (0.85mmol) of obtained compound (K) and 210 mg (0. 82 mmol) of silver trifluoromethanesulfonate, 50 mL of toluenewas added. The resultant mixture was heated under reflux for 3 hours under a nitrogen atmosphere. The obtained reaction solution was left standing until the temperature was cooled to room temperature and then filtered through Celite. After the solvent was distilled off under a reduced pressure, the residue was purified by a silica gel column chromatography using a eluent of chloroform / ethyl acetate = 1/1 and recrystallized from a mixed solution of dichloromethane / hexane to obtain 110 mg (0.13 mmol) of polymerizable compound 1-1 (d) with a yield of 16 %.
¹H NMR: 7.76 (m, 3 H), 7.63 (m, 9 H), 7.29 (m, 3 H), 7.1 - 6.6 (m, 11 H), 5.67 (d, 1 H), 5.16 (d, 1 H), 3.11 (s, 6 H), 3.05 (s, 6 H), 2.71 (m, 4 H). FAB-MS: 871 (M⁺). Elementary analysis Calcd for C₄₇H₄₄IrN₅: C, 64.80; H, 5.09; N, 8.04. Found: C, 65.26; H, 4.99; N, 8.15.

### Comparative Example 1 (d) : Synthesis of comparative polymerizable compound (1-2(d))

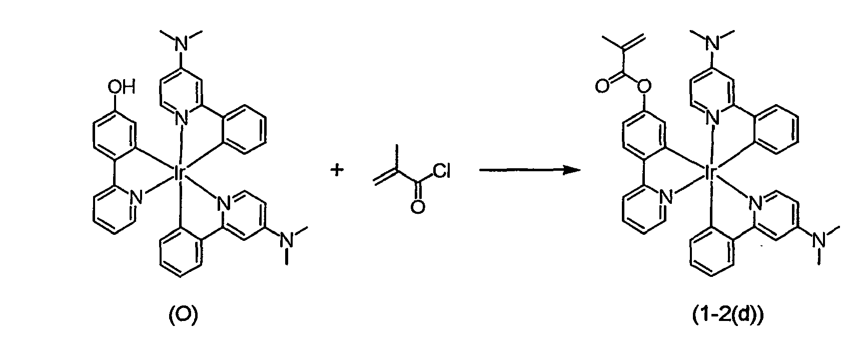

500 mg (0.66 mmol) of iridium complex (O), synthesized in the same manner as synthesis of iridium complex (E) except for using iridium complex (N) instead of iridium complex (A), was dissolved in 30 mL of dichloromethane. To this was added dropwise 5 mL of dichloromethane solution of 100 mg (0.96 mmol) of methacryloyl chloride and the resultant mixture was stirred for 1 hour at the room temperature. Subsequently, the solvent was distilled off under a reduced pressure, and the residue was purified by a silica gel column chromatography using a eluent (chloroform / ethyl acetate = 1/1) and recrystallized from a mixed solution of dichloromethane / hexane to obtain 400 mg (0.48 mmol) of polymerizable compound 1-2(d) with a yield of 73 %.
¹H NMR: 7.85 (m, 3 H), 7.58 (m, 9 H), 7.22 (m, 3 H), 7.00 (m, 6 H), 6.15 (s, 1 H), 5.55 (s, 1 H), 3.11 (s, 6 H), 3.05 (s, 6 H), 1.93 (s, 3H). FAB-MS: 825 (M⁺). Elementary analysis Calcd for C₄₁H₃₈IrN₅O₂: C, 59.69; H, 4.64; N, 8.49. Found: C, 60.02; H, 4.59; N, 8.17.

### Example 1 (e): Synthesis of polymerizable compound (1-1(e))

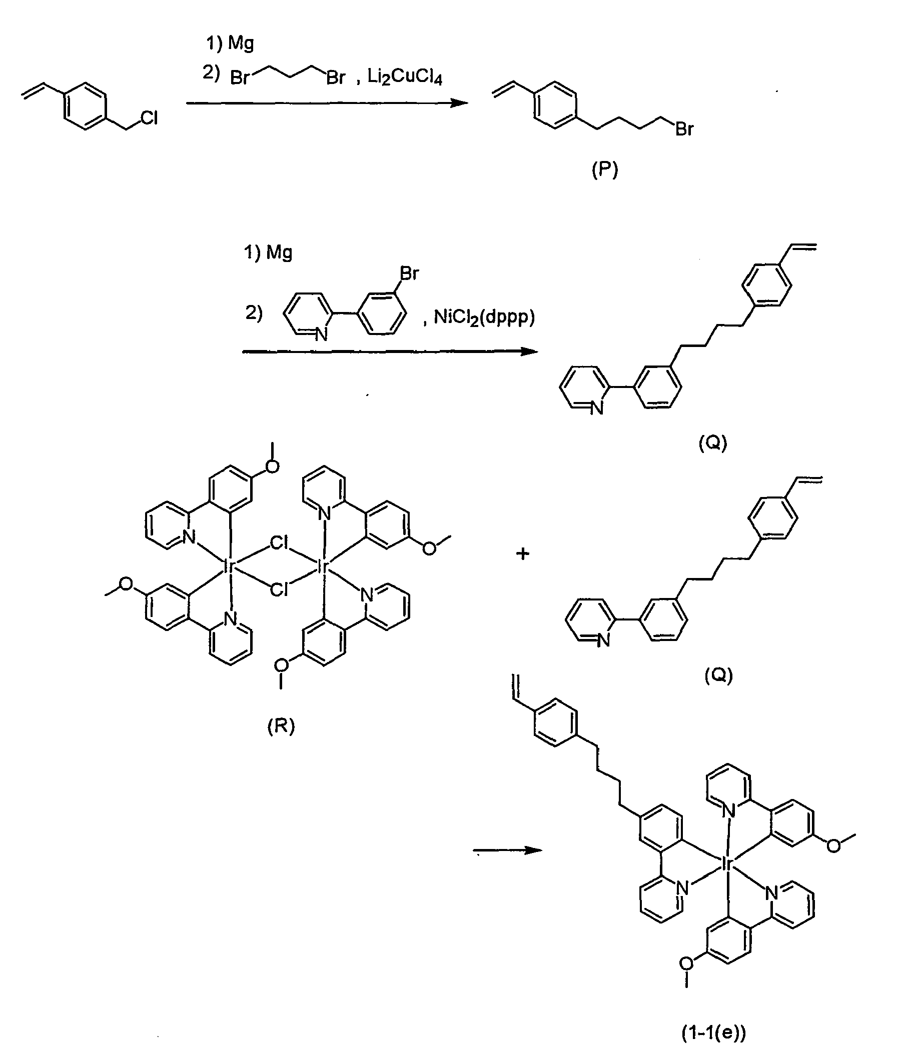

1.70 g (70 mmol) of magnesium was weighed and charged into a reaction vessel filled with nitrogen atmosphere, and 50 mL of THF was added thereto. To this was added dropewise 100 mL of diethyl ether solution of 10.0 g (66 mmol) of 4-vinylbenzyl chloride over 2 hours. After dropping, the solution was further stirred for 1 hour at the room temperature and then 100 mL of THF solution of 13.3 g (66 mmol) of 1, 3-dibromopropane and 0. 6 mmol of lithium tetrachlorocuprate (II) was added dropwise thereto while cooling in an ice bath. After stirring for 6 hours at the room temperature, the generated precipitate was separated by filtration and the solvent was distilled off under a reduced pressure. The residue was purified by distillation under a reduced pressure to thereby obtain 11.5 g (48 mmol) of compound (P) with a yield of 73 %.

0.25 g (10.3 mmol) of magnesium was weighed and charged into a reaction vessel filled with nitrogen atmosphere, and 10 mL of THF solution of 2.01g (8.4 mmol) of obtained compound (P) was dripped over 30 minutes. After the solution was stirred for 2 hours at the room temperature, 10 mL of THF solution of 0.70 g (2.9 mmol) of 2- (3-bromophenyl) pyridine (synthesized in the same manner as synthesis of compound (C) except for using 3-bromophenyl boronic acid in place of 4-methoxyphenylboronic acid) and 100 mg (0.18 mmol) of dichloro(1,2-bis(diphenylphosphino)propane) nickel was dripped thereto while cooling in an ice bath. The mixture was stirred for 12 hours at the room temperature and then 100 mL of water was added thereto to extract organic product with ethyl acetate. Then, the obtained solution was washed with water and saturated saline and dried over magnesium sulfate. After the solvent was distilled off under a reduced pressure, the residue was purified by a silica gel column chromatography using a eluent (hexane/chloroform = 1/3) to obtain 0.5 g (1.6 mmol) of compound (Q) with a yield of 55 %.

To a mixture of 500 mg (0.42 mmol) of iridium complex (R), synthesized in the same manner as synthesis of iridium complex (A) except for using compound (C) in place of 2-phenyl pyridine, 280 mg (0.89 mmol) of obtained compound (Q) and 230 mg (0.90 mmol) of silver trifluoromethanesulfonate, 50 mL of toluene was added. The resultant mixture was heated under reflux for 3 hours under a nitrogen atmosphere. The obtained reaction liquid was left standing until the temperature was cooled to room temperature and then filtered through Celite. After the solvent was distilled off under a reduced pressure, the residue was purified by a silica gel column chromatography using a eluent (chloroform /hexane = 3/1) and recrystallized from a mixed solution of dichloromethane/methanol to obtain 40 mg (0.046 mmol) of polymerizable compound 1-1(e) with a yield of 5 %.
¹H NMR: 7.85 (m, 3 H), 7.7-6.6 (m, 23 H), 5.67 (d, 1 H), 5.17 (d, 1 H), 3.89 (s, 3 H), 3.81 (s, 3 H), 2.57 (m, 4 H), 1.64 (m, 4H). FAB-MS: 873 (M⁺). Elementary analysis Calcd for C₄₇H₄₂IrN₃O₂: C, 64.66; H, 4.85; N, 4.81. Found: C, 64.23; H, 4.91; N, 4.74.

### Comparative Example 1 (e) : Synthesis of comparative polymerizable compound (1-2(e))

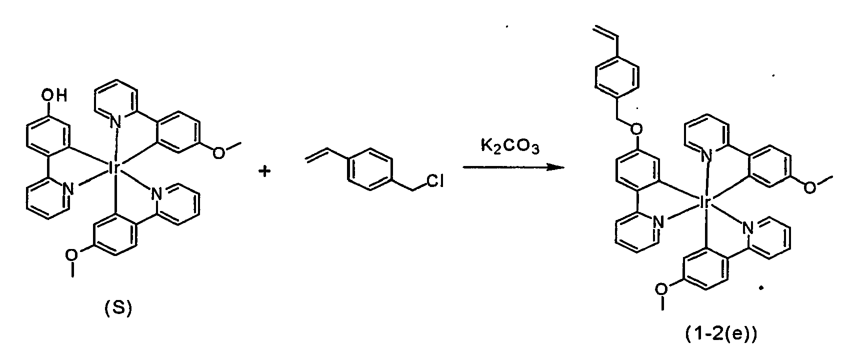

To a mixture of 450 mg (0.62 mmol) of iridium complex (S), synthesized in the same manner as synthesis of iridium complex (E) except for using iridium complex (R) instead of iridium complex (A), and 300 mg (2.2 mmol) of potassium carbonate, 100 mL of acetone was added, and further, 300 mg (2.0 mmol) of 4-vinylbenzyl chloride was added thereto. The resultant mixture was heated under reflux for 24 hours under a nitrogen atmosphere. After the obtained reaction mixture was filtered by glass filter, the filtrate was concentrated under a reduced pressure. The residue was purified by a silica gel column chromatography using a eluent of chloroform and recrystallized from a mixed solution of dichloromethane/methanol to obtain 390 mg (0.46 mmol) of comparative polymerizable compound 1-2 (e) with a yield of 74 %. ¹H NMR: 7.90 (m, 3 H), 7.60 (m, 11 H), 7.20 (d, 2 H), 6.95 (m, 9 H), 6.70 (dd, 1 H), 5.41 (d, 1 H), 4.95 (d, 1 H), 4.60 (s, 2 H), 4.02 (s, 3 H), 3.96 (s, 3 H). FAB-MS : 847 (M⁺). Elementary analysis Calcd for C₄₄H₃₆IrN₃O₃: C, 62.39; H, 4.28; N, 4.96. Found: C, 62.54; H, 4.11; N, 5.06.

### Example 1 (f): Synthesis of polymerizable compound (1-1(f))

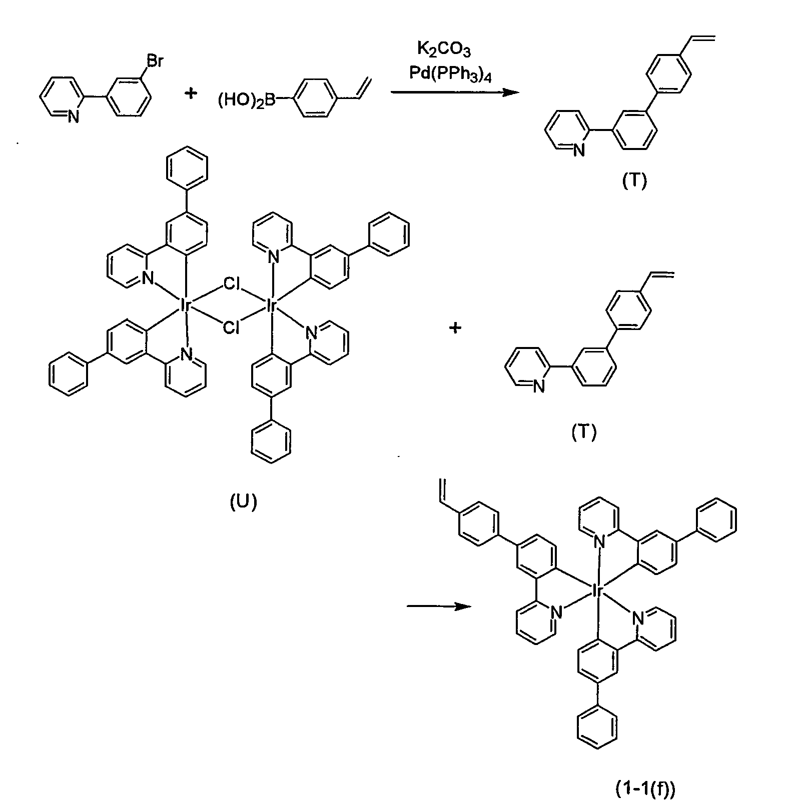

3.0 g (13 mmol) of 2- (3-bromophenyl) pyridine synthesized in the same manner as synthesis of compound (C) except for using 3-bromophenylboronic acid instead of 4-methoxy boronic acid and 2.0 g (14 mmol) of 4-vinylphenylboronic acid were dissolved in 30 mL of 1,2-dimethoxyethane. To this was added 20 mL of aqueous solution of 152 mg (0.13 mmol) of tetrakis(triphenylphosphine)palladium and 4.8 g (34 mmol) of potassium carbonate, and the mixture was heated under reflux for 3 hours under a nitrogen atmosphere. After the obtained reaction solution was left standing until the temperature was cooled to room temperature, 100 mL of water and 100 mL of ethyl acetate were added and the mixture was shaken. The organic layer was dried over magnesium sulfate and then the solvent was distilled off under a reduced pressure. The residue was purified by a silica gel column chromatography using a eluent of a chloroform to obtain 2.5 g (10 mmol) of compound (T) with a yield of 77 %.

To a mixture of 700 mg (0.51 mmol) of iridium complex (U), synthesized in the same manner as synthesis of iridium complex (A) except for using 2-(3-biphenyl) pyridine (synthesized in the same manner as synthesis of compound (C) except for using 3-biphenylboronic acid in place of 4-methoxyphenylboronic acid) in place of 2-phenyl pyridine, 300 mg (1.17 mmol) of obtained compound (T) and 270 mg (1.05 mmol) of silver trifluoromethanesulfonate, 70 mL of toluene was added and the resultant mixture was heated under reflux for 3 hours under a nitrogen atmosphere. The obtained reaction solution was left standing until the temperature was cooled to room temperature and then filtered through Celite. After the solvent was distilled off under a reduced pressure, the residue was purified by a silica gel column chromatography using a eluent of chloroform and recrystallized from a mixed solution of dichloromethane/methanol to obtain 70 mg (0.077 mmol) of polymerizable compound 1-1 (f) with a yield of 8 %.
¹H NMR: 7.80 (m, 3 H), 7.6-6.6 (m, 33 H), 6.15 (s, 1H), 5.55 (s, 1 H), 1.93 (s, 3 H). FAB-MS: 891 (M⁺) . Elementary analysis Calcd for C₄₉H₃₆IrN₃O₂: C, 66.05; H, 4.07; N, 4.72. Found: C, 66.39; H, 3.94; N, 4.66.

### Comparative Example 1 (f) : Synthesis of comparative polymerizable compound (1-2(f))

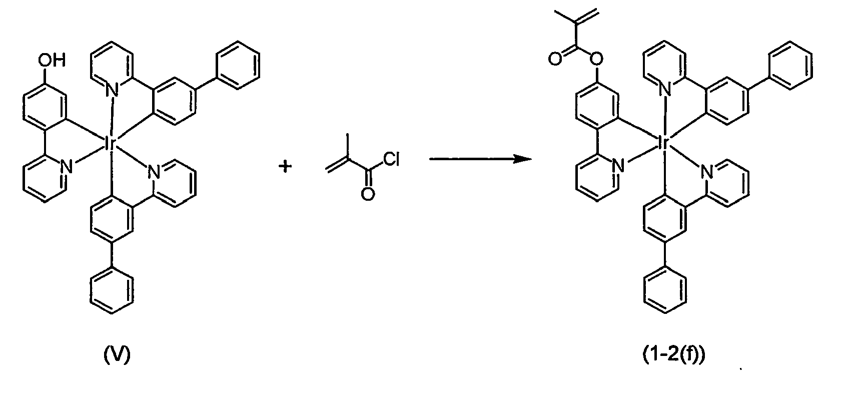

500 mg (0.61 mmol) of iridium complex (V), synthesized in the same manner as synthesis of iridium complex (E) except for using iridium complex (U) instead of iridium complex (A), was dissolved in 30 mL of dichloromethane. To this was added dropwise 5 mL of dichloromethane solution of 100 mg (0.96 mmol) of methacryloyl chloride and stirred for 1 hour at the room temperature. Subsequently, the solvent was distilled off under a reduced pressure and the residue was purified by a silica gel column chromatography using a eluent (chloroform/ethyl acetate = 9/1) and recrystallized from a mixed solution of dichloromethane/hexane to obtain 430 mg (0.48 mmol) of polymerizable compound 1-2(f) with a yield of 79 %.
¹H NMR: 7.80 (m, 3 H), 7.6- 6.6 (m, 33 H), 6.15 (s, 1 H), 5.55 (s, 1 H), 1.93 (s, 3 H). FAB-MS: 891 (M⁺). Elementary analysis Calcd for C₄₉H₃₆IrN₃O₂: C, 66.05; H, 4.07; N, 4.72. Found: C, 66.39; H, 3.94; N, 4.66.

### Example 1 (g): Synthesis of polymerizable compound (1-1(g))

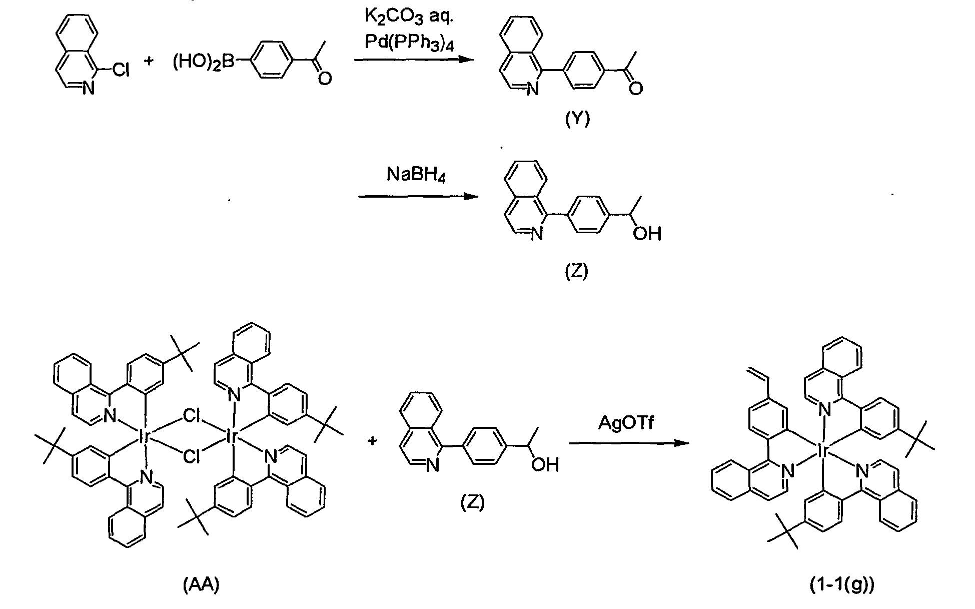

5.00 g (33 mmol) of 1-chloroisoquinoline, 5.50 g (34 mmol) of acetylphenylboronic acid and 350 mg (0.30 mmol) of tetrakis(triphenylphosphine)palladium were dissolved in 50 mL of 1,2-dimethoxyethane, and 50 mL of an aqueous solution of 12.3 g (89 mmol) of potassium carbonate was added thereto. Then, the mixture was heated under reflux for 3 hours under a nitrogen atmosphere. The obtained reaction solution was left standing while the temperature was cooled to room temperature. To this was added 100 mL of water and 100 mL of ethyl acetate, and the mixture was shaken. The organic layer was dried over magnesium sulfate and then the solvent was distilled off under a reduced pressure. The residue was purified by a silica gel column chromatography using an eluent (chloroform/ethyl acetate = 19/1) to thereby obtain 7.25 g (29 mmol) of compound (Y) with a yield of 89 %.

After 5.03 g (20 mmol) of the obtained compound (Y) was dissolved in 50 mL of methanol, 1.13 g (30 mmol) of sodium tetrahydroborate was portionwise added thereto and the resultant mixture was stirred for 3 hours at the room temperature. After adding 30 mL of water to the obtained reaction solution, it was concentrated under reduced pressure. By washing and then drying under reduced pressure, 4.81 g (19 mmol) of crystal compound (Z) was obtained with a yield of 96 %.

Next, to a mixture of 610 mg (0.41 mmol) of iridium complex (AA) synthesized in the same manner as the synthesis method of iridium complex (G) except for using 1-chloroisoquinoline in place of 2-bromopyridine, 220 mg (0.88 mmol) of the obtained compound (Z) and 210 mg (0.82 mmol) of silver trifluoromethanesulfonate, 50 mL of toluene was added. The resultant mixture was heated under reflux for 3 hours under a nitrogen atmosphere. The obtained reaction solution was left standing while the temperature was cooled to room temperature and then filtered by Celite. After the solvent was distilled off under a reduced pressure, the residue was purified by a silica gel column chromatography using a eluent of chloroform and recrystallized from a mixed solution of dichloromethane/methanol to obtain 160 mg (0.17 mmol) of polymerizable compound 1-1(g) with a yield of 21 %.
¹H-NMR: 9.8 - 6.9 (m, 28 H), 5.61 (d, 1 H), 5.25 (d, 1 H), 1.05 (s, 18 H). FAB-MS: 943 (M⁺). Elementary analysis Calcd for C₅₅H₄₈IrN₃: C, 70.04; H, 5.13; N, 4.46. Found: C, 69.77; H, 5.26; N, 4.71.

### Comparative Example 1 (g) : Synthesis of comparative polymerizable compound (1-2(g))

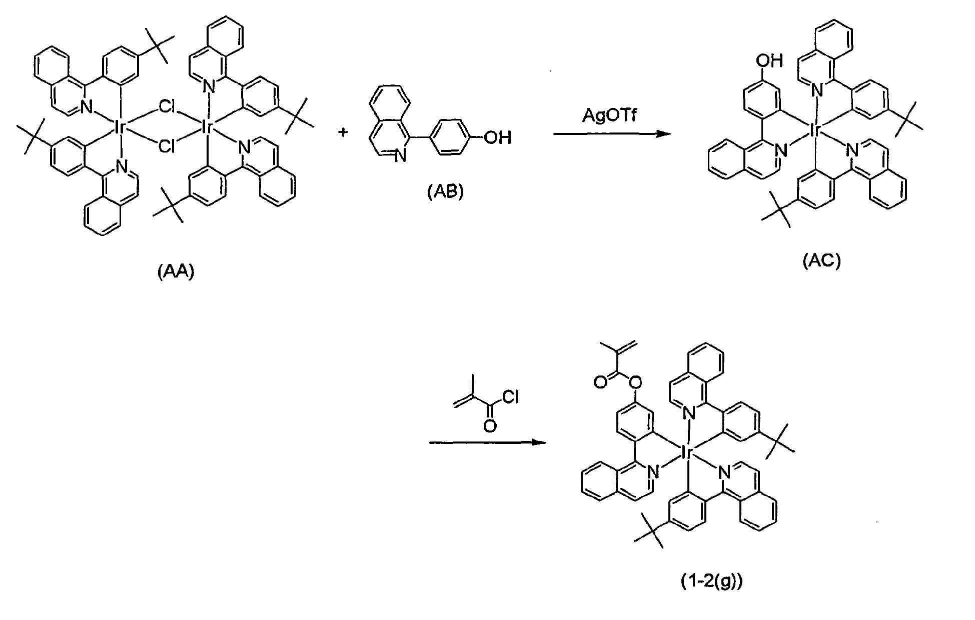

To a mixture of 160 mg (0.72 mmol) of compound (AB) synthesized in the same manner as the synthesis method of compound (D) except for using 1-chloroisoquinoline in place of 2-bromopyridine, 505 mg (0.34 mmol) iridium complex (AA) and 180 mg (0.70 mmol) of silver trifluoromethanesulfonate, 50 mL of toluene was added and the resultant mixture was heated under reflux for 3 hours under a nitrogen atmosphere. After the obtained reaction solution was left standing while the temperature was cooled to room temperature, it was filtered by Celite and the solvent was distilled off under a reduced pressure. The residue was purified by a silica gel column chromatography using a eluent (chloroform/ethyl acetate = 9/1) and recrystallized from a mixed solution of dichloromethane/methanol to obtain 66 mg (0.071 mmol) of iridium complex (AC) with a yield of 10 %.

65 mg (0.070 mmol) of obtained iridium complex (AC) was dissolved in 10 mL of dichloromethane. To this was added dropwise 5 mL of dichloromethane solution of 20 mg (0.19 mmol) of methacryloyl chloride and the resultant solution was stirred for 3 hours at the room temperature. Subsequently, the solvent was distilled off under a reduced pressure, and the residue was purified by a silica gel column chromatography using a eluent (chloroform / ethyl acetate = 9/1) and recrystallized from a mixed solution of dichloromethane / hexane to obtain 50 mg (0.050 mmol) of polymerizable compound 1-2 (g) with a yield of 71 %.
¹H-NMR: 9. 8 - 6.9 (m, 27 H), 6.20 (s, 1 H), 5.49 (s, 1 H), 1. 95 (s, 3 H), 1.09 (s, 9 H), 1.07 (s, 9 H). FAB-MS: 1001 (M⁺). Elementary analysis Calcd for C₅₇H₅₀IrN₃O₂: C, 68.38; H, 5.03; N, 4.20. Found: C, 68.51; H, 5.00; N, 4.04.

### Example 1 (h): Synthesis of polymerizable compound (1-1(h))

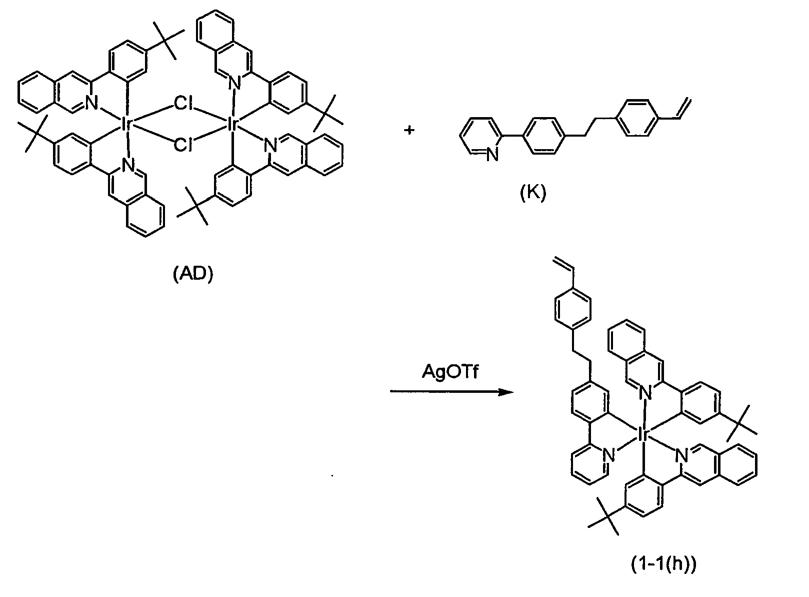

To a mixture of 583 mg (0.39 mmol) of iridium complex (AD) synthesized in the same manner as the synthesis method of iridium complex (G) except for using 3-(4-tert-butylphenyl)isoquinoline (synthesized in the same manner as synthesis of 2- (4-tert-butylphenyl) pyridine except for using 3-chloroisoquinoline in place of 2-bromopyridine) in place of 2-(4-tert-butylphenyl) pyridine, 225 mg (0.79mmol) of compound (K) and 200 mg (0.78 mmol) of silver trifluoromethanesulfonate, 50 mL of toluene was added and the resultant mixture was heated under reflux for 3 hours under a nitrogen atmosphere. The obtained reaction solution was left standing was while the temperature was cooled to room temperature and then filtered by Celite. After the solvent was distilled off under a reduced pressure, the residue was purified by a silica gel column chromatography using a eluent of chloroform and recrystallized from a mixed solution of dichloromethane/methanol to obtain 138 mg (0.13 mmol) of polymerizable compound 1-1(h) with a yield of 17 %.
¹H-NMR: 8.9 - 6.8 (m, 32 H), 5.75 (d, 1 H), 5.33 (d, 1 H), 2.75 (m, 4 H), 1.08 (s, 9 H), 1.06 (s, 9 H). FAB-MS: 1047 (M⁺) . Elementary analysis Calcd for C₆₃H₅₆IrN₃: C, 72.25; H, 5.39; N, 4.01. Found: C, 72.08; H, 5.46; N, 4.33.

### Comparative Example 1 (h) : Synthesis of comparative polymerizable compound (1-2(h))

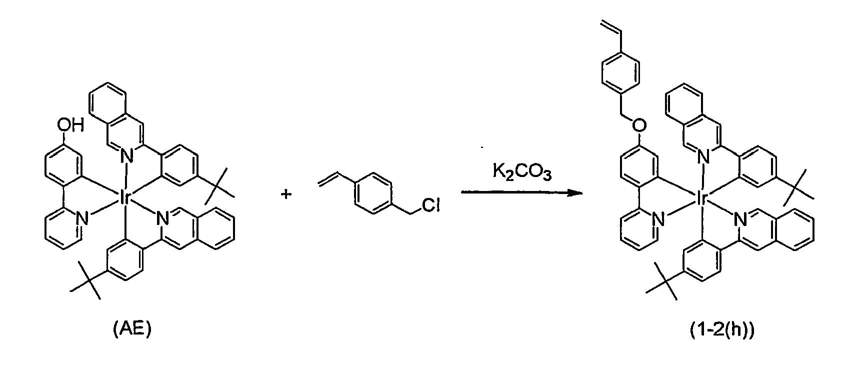

To a mixture of 111 mg (0.13 mmol) of iridium complex (AE) synthesized in the same manner as the synthesis method of iridium complex (E) except for using iridium complex (AD) in place of iridium complex (A) and 200 mg (1. 3 mmol) of potassium carbonate, 15 mL of acetone was added. Further, 200 mg (1.4 mmol) of 4-vinylbenzyl chloride was added thereto and the mixture was heated under reflux for 24 hours under a nitrogen atmosphere. After the obtained reaction mixture was filtered by glass filter, the filtrate was concentrated under a reduced pressure. The residue was purified by a silica gel column chromatography using a eluent of chloroform and recrystallized from a mixed solution of dichloromethane/hexane to obtain 85 mg (0.085 mmol) of comparative polymerizable compound 1-2(h) with a yield of 65 %. ¹H-NMR: 8.9 - 6.8 (m, 32 H), 5.52 (d, 1 H), 5.03 (d, 1 H), 4.37 (s, 2 H), 1.09 (s, 9 H), 1.06 (s, 9 H). FAB-MS: 1001 (M⁺) . Elementary analysis Calcd for C₅₈H₅₄IrN₃O: C, 69.57; H, 5.44; N, 4.20. Found: C, 69.39; H, 5.51; N, 4.34.

### Example 2 (a) to (h) and Comparative Example 2 (a) to (h): Synthesis of copolymer of polymerizable iridium complex and polymerizable compound (W) and (X)

80 mg of polymerizable iridium complex synthesized in Example 1 and Comparative Example 1 (Examples 1-1(a) to 1-1(h), Comparative Examples 1-2 (a) to 1-2(h)), 460 mg of polymerizable compound (W) and 460 mg of polymerizable compound (x) were placed in an airtight vessel, and thereto was added 9.9 mL of dry toluene. To this was added 198 µl of a 0.1 M toluene solution of V-601 (manufactured by Wako Pure Chemical Industries, Ltd.), and the resulting solution was subjected to freezing-degassing treatment 5 times. The vessel was tightly closed under vacuum, and the solution was stirred at 60°C for 60 hours. After the reaction, the reaction solution was added to 500 mL of acetone dropwise to generate precipitates. The precipitates were purified by repeating reprecipitation in a toluene-acetone solvent 2 times, and vacuum-dried at 50 °C overnight, to thereby obtain the target copolymer (Example 2-1 (a) to 2-1(h), Comparative Example 2-2(a) to 2-2(h)). Table 1 shows yields, weight average molecular weight (Mw) values estimated by GPC measurement in terms of polystyrene and the respective copolymerization mass ratio in each copolymer estimated by the ICP elemental analysis and ¹³C-NMR measurement results.

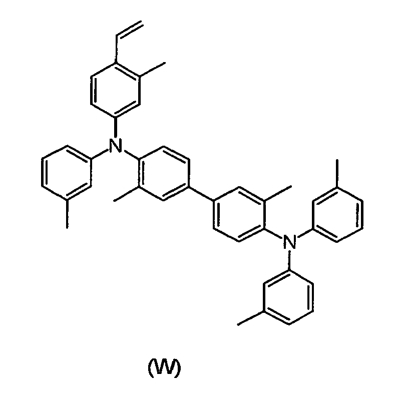

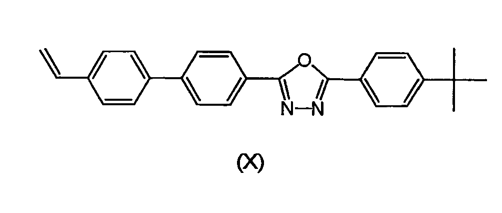

**Table 1**

| | iridium complex | copolymer | yield (%) | Mw (×10⁻³) | copolymerization ratio (mass ratio) | | |
|---|---|---|---|---|---|---|---|
| | | | | | iridium complex | Compound (W) | Compound (X) |
| Ex 2(a) | 1-1(a) | 2-1(a) | 78 | 4.2 | 7.5 | 46.1 | 46.4 |
| Comp.Ex 2(a) | 1-2(a) | 2-2(a) | 79 | 5.1 | 7.3 | 46.3 | 46.4 |
| Ex.2(b) | 1-1(b) | 2-1(b) | 75 | 4.5 | 7.6 | 46.3 | 46.1 |
| Comp. Ex.2 (b) | 1-2(b) | 2-2(b) | 79 | 4.8 | 7.4 | 46.6 | 46.0 |
| Ex 2(c) | 1-1(c) | 2-1(c) | 77 | 6.4 | 7.4 | 46.1 | 46.5 |
| Comp. Ex.2 (c) | 1-2(c) | 2-2(c) | 80 | 5.5 | 7.3 | 46.4 | 46.3 |
| Ex 2(d) | 1-1(d) | 2-1(d) | 79 | 3.9 | 7.6 | 46.2 | 46.2 |
| Comp. Ex2 (d) | 1-2(d) | 2-2(d) | 77 | 6.1 | 7.5 | 46.2 | 46.3 |
| Ex. 2 (e) | 1-1(e) | 2-1(e) | 78 | 5.0 | 7.5 | 46.6 | 45.9 |
| Comp. Ex.2 (e) | 1-2(e) | 2-2(e) | 76 | 4.7 | 7.6 | 46.3 | 46.1 |
| En 2 (f) | 1-1(f) | 2-1(f) | 80 | 4.8 | 7.3 | 46.4 | 46.3 |
| Comp.Ex.2 (f) | 1-2(f) | 2-2(f) | 79 | 5.1 | 7.4 | 46.4 | 46.2 |
| Ex 2(g) | 1-1(g) | 2-1(g) | 76 | 5.5 | 7.3 | 46.3 | 46.4 |
| Comp. Ex.2 (h) | 1-2(g) | 2-2(g) | 79 | 6.1 | 7.4 | 46.1 | 46.5 |
| Ex.2(f) | 1-1(h) | 2-1(h) | 79 | 4.7 | 7.5 | 46.3 | 46.2 |
| Comp. Ex.2 (h) | 1-2(h) | 2-2(h) | 70 | 6.0 | 7.5 | 46.5 | 46.0 |

### Example 3(a) to (h) and Comparative Example 3(a) to (h): Production of organic light emitting element and evaluation of EL properties

An organic light emitting element (Examples 3-1(a) to 3-1(h), Comparative Examples 3-2(a) to 3-2 (h)) was produced using an ITO (indium tin oxide)-coated substrate (Nippo Electric Co., Ltd.) which was a 25-mm-square glass substrate with two 4-mm-width ITO electrodes formed in stripes as an anode on one surface of the substrate. First poly (3, 4-ethylenedioxythiophene)-polystyrene sulfonate (BAYTRON P (trade name) manufactured by Bayer Co.) was applied onto the ITO anode of the ITO-having substrate by a spin coating method under conditions of a rotation rate of 3,500 rpm and a coating time of 40 seconds, and dried under a reduced pressure at 60°C for 2 hours in a vacuum drying apparatus, to form an anode buffer layer. The obtained anode buffer layer had a film thickness of approximately 50 nm. Then, 90 mg of each of the polymer light emitting materials synthesized in Examples 2-1 (a) to 2-1 (h) and Comparative Examples 2-2 (a) to 2-2 (h) was dissolved in 2,910 mg of toluene (special grade, manufactured by Wako Pure Chemical Industries, Ltd.), and the obtained solution was passed through a filter with a pore size of 0.2 µm to obtain a coating solution. Next, the prepared coating solution was applied onto the anode buffer layer by a spin coating method under conditions of a rotation rate of 3,000 rpm and a coating time of 30 seconds, and dried at the room temperature (25°C) for 30 minutes, to form a light emitting layer. The obtained light emitting layer had a film thickness of approximately 100 nm. Then the substrate with the light emitting layer formed thereon was placed in a deposition apparatus, calcium and aluminum were codeposited in a weight ratio of 1:10 to form two cathodes in the form of stripes of 3 mm in width in a direction perpendicular to the longitudinal direction of the anodes. The obtained cathodes had a film thickness of about 50 nm. Finally, in an argon atmosphere, lead wires (wiring) were attached to the anodes and cathodes to fabricate four organic light emitting elements of 4 mm (length) × 3 mm (width). Voltage was applied to the above-mentioned organic EL elements by using a programmable direct voltage/current source TR6143 manufactured by Advantest Corporation to cause luminescence and the luminance was measured by using a luminance meter BM-8 manufactured by Topcon Corporation. The obtained values of maximum external quantum efficiency, maximum luminance and brightness half-life when constant current is applied, assuming that the initial luminance is 100 cd/m², are shown in Table 2.

**Table 2**

| | Element No. | Polymer Emitting Material | Maximum External Quantum Efficiency (%) | Maximum Luminance (cd/m²) | Brightness Half-life (h) |
|---|---|---|---|---|---|
| Ex.3(a) | 3-1 (a) | 2-1 (a) | 7.6 | 72000 | 2200 |
| Comp. Ex.3(a) | 3-2 (a) | 2-2 (a) | 4.1 | 31000 | 500 |
| Ex.3 (b) | 3-1 (b) | 2-1 (b) | 8.9 | 88000 | 4500 |
| Comp. Ex.3(b) | 3-2(b) | 2-2 (b) | 3.9 | 40000 | 600 |
| Ex.3 (c) | 3-1 (c) | 2-1 (c) | 4.7 | 59000 | 1300 |
| Comp. Ex.3(c) | 3-2 (c) | 2-2 (c) | 1.4 | 16000 | 200 |
| Ex.3 (d) | 3-1 (d) | 2-1 (d) | 5.0 | 46000 | 1900 |
| Comp. Ex.3(d) | 3-2 (d) | 2-2 (d) | 1.9 | 21000 | 200 |
| Ex.3 (e) | 3-1 (e) | 2-1 (e) | 4.5 | 39000 | 1100 |
| Comp. Ex. 3(e) | 3-2 (e) | 2-2 (e) | 2.1 | 14000 | 100 |
| Ex. 3 (f) | 3-1 (f) | 2-1 (f) | 6.2 | 65000 | 3300 |
| Comp. Ex.3(f) | 3-2 (f) | 2-2 (f) | 3.0 | 20000 | 500 |
| Ex. 3 (g) | 3-1 (g) | 2-1 (g) | 5.9 | 22000 | 1700 |
| Comp. Ex.3(g) | 3-2 (g) | 2-2 (g) | 1.6 | 7000 | 200 |
| Ex.3 (h) | 3-1 (h) | 2-1 (h) | 4.8 | 46000 | 1100 |
| Comp. Ex.3(h) | 3-2 (h) | 2-2 (h) | 2.0 | 11000 | 200 |

It is clear from Table 2 that the light emitting elements of the present invention (Examples 3 (a) to (h)) using the polymer light emittingmaterials (Examples 2 (a) to (h)) each obtained by polymerizing iridium complex wherein the polymerizable substituent consists only of hydrocarbon showed high emission efficiencies, long brightness life and high maximum luminance as compared with the comparative corresponding elements (Comparative Examples 3 (a) to (h)) using the polymer light emitting materials (Comparative Examples 2 (a) to (h)) obtained by polymerizing iridium complex wherein the polymerizable substituent comprises oxygen as a hetero atom.

### INDUSTRIAL APPLICABILITY

An organic light-emitting element excellent in light-emission efficiency and durability can be obtained by using the polymer light-emitting material of the present invention where a phosphorescent iridium complex is bonded, and in addition, a large-area device can be easily manufactured by employing coating film-forming method.

## Claims

1. A polymer light-emitting material, which is obtained by (co)polymerizing one or more polymerizable compounds having a substituent in which a polymerizable double bond moiety represented by formula (2): 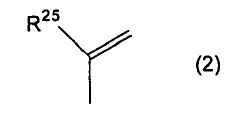 (wherein R²⁵ represents a hydrogen atom or a straight-chain alkyl group having 1 to 5 carbon atoms) is bonded to one of the carbon atoms of an aromatic ring,
wherein at least one of the polymerizable compounds is an iridium complex represented by formula (1): 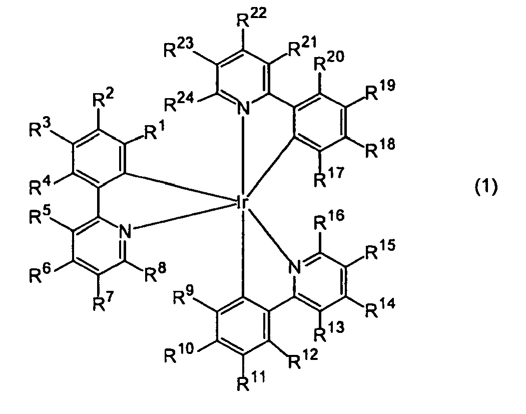 wherein R¹ to R²⁴ each independently represents a hydrogen atom, a halogen atom, a cyano group, an alkyl group having 1 to 10 carbon atoms, an aryl group having 6 to 10 carbone atoms, an amino group which may be substituted by an alkyl group having 1 to 10 carbon atoms, an alkoxy group having 1 to 10 carbon atoms or a silyl group, with a proviso that one of R² to R⁷ is a polymerizable substituent selected from a polymerizable double bond moiety represented by formula (2), an aromatic ring group where a polymerizable double bond moiety represented by formula (2) is bonded to one of the carbon atoms of the ring and a hydrocarbon group which is substituted with the aromatic ring group having a polymerizable double bond moiety represented by formula (2) and does not contains a hetero atom.

2. The polymer light-emitting material as claimed in claim 1, wherein R¹, R⁴, R⁵, R⁸, R⁹, R¹², R¹³, R¹⁶, R¹⁷, R²⁰, R²¹ and R²⁴ in formula (1) are hydrogen atoms.

3. The polymer light-emitting material as claimed in claim 1, wherein the polymerizable substituent is a vinyl group or a group represented by formula (3) 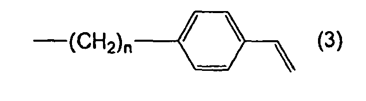 wherein n represents 0 or an integer of 1 to 10.

4. The polymer light-emitting material as claimed in claim 1, which is a copolymer of at least one carrier-transporting compound and a polymerizable iridium complex represented by formula(1),
wherein the carrier-transporting compound is a hole-transporting compound selected from

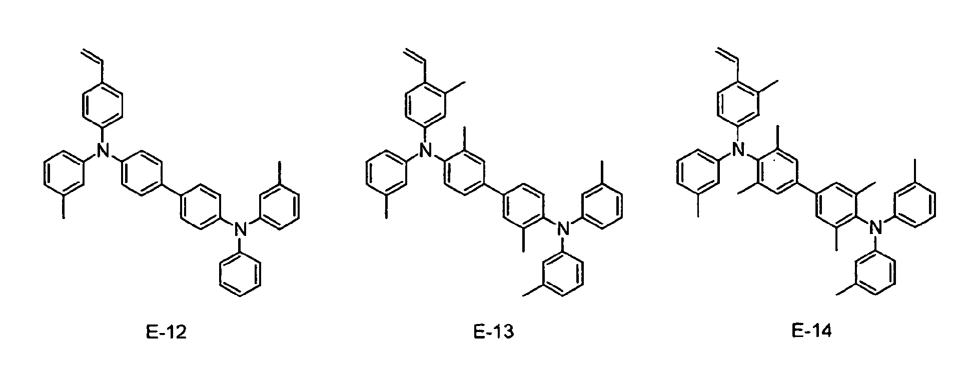

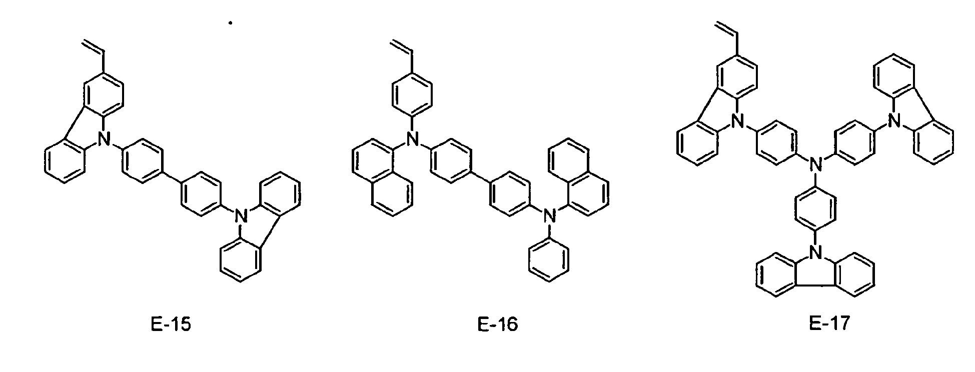

5. The polymer light-emitting material as claimed in claim 1, which is obtained by copolymerizing two or more kinds of polymerizable compounds containing a polymerizable compound represented by formula (4) and a polymerizable iridium complex represented by formula (1).

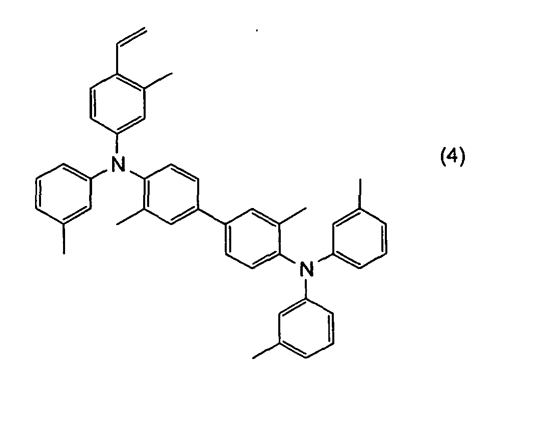

6. The polymer light-emitting material as claimed in claim 1, which is a copolymer of at least one carrier-transporting compound and a polymerizable iridium complex represented by formula (1), wherein the carrier-transporting compound is an electron-transporting compound selected from

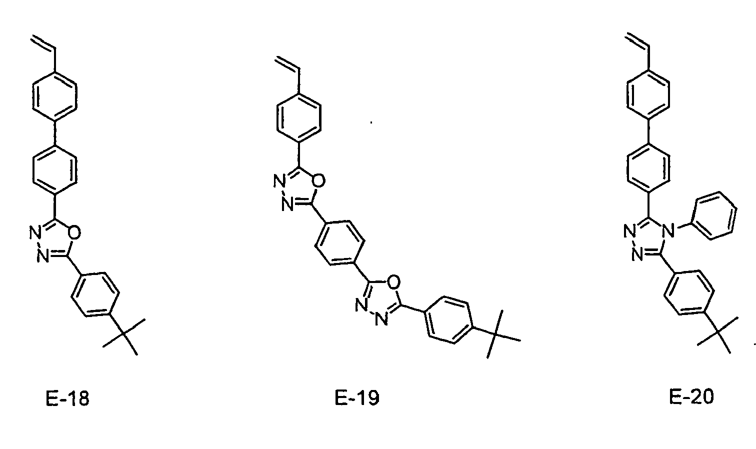

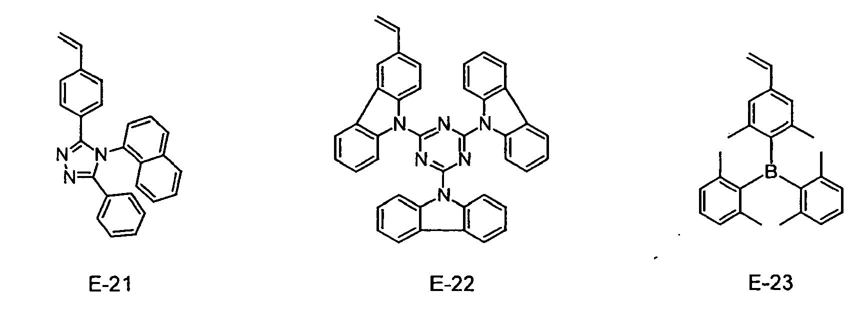

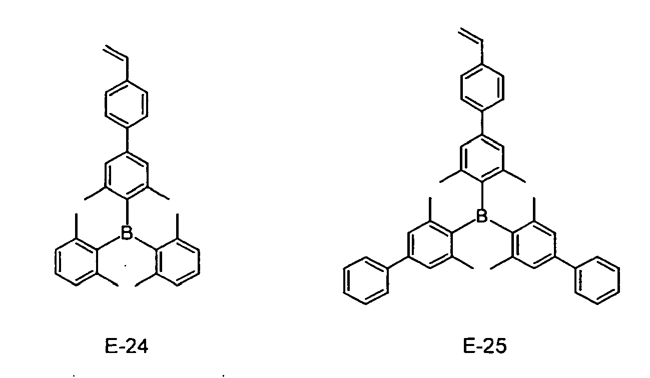

7. The polymer light-emitting material as claimed in claim 1, which is obtained by copolymerizing two or more kinds of polymerizable compounds containing a polymerizable compound represented by formula (5) and a polymerizable iridium complex represented by formula (1).

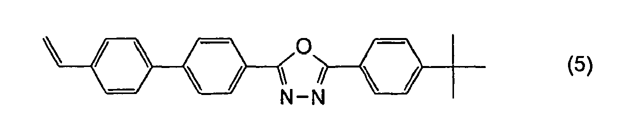

8. The polymer light-emitting material as claimed in claim 1, which is a copolymer of polymerizable compounds containing an iridium complex represented by formula (1), a hole-transporting compound selected from 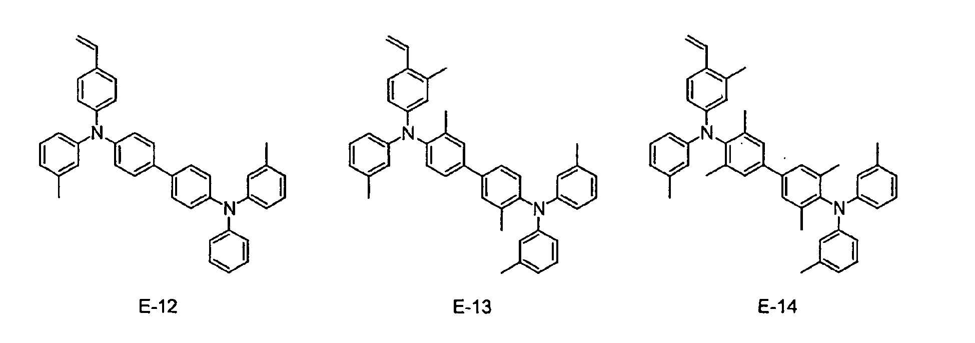 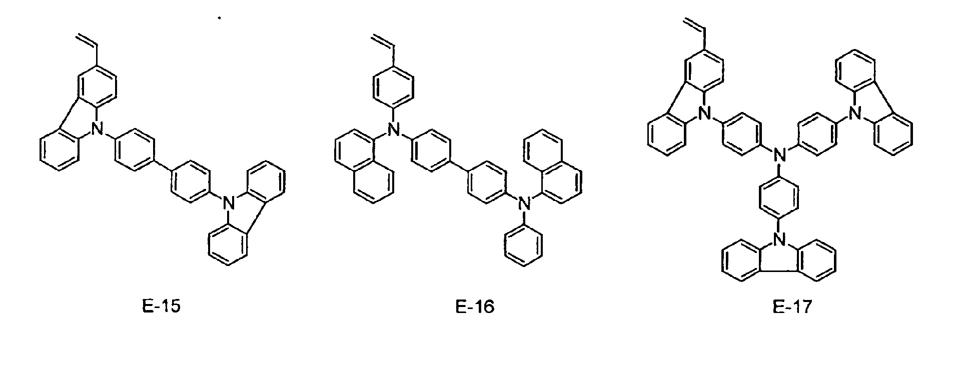 and an electron-transporting compound selected from

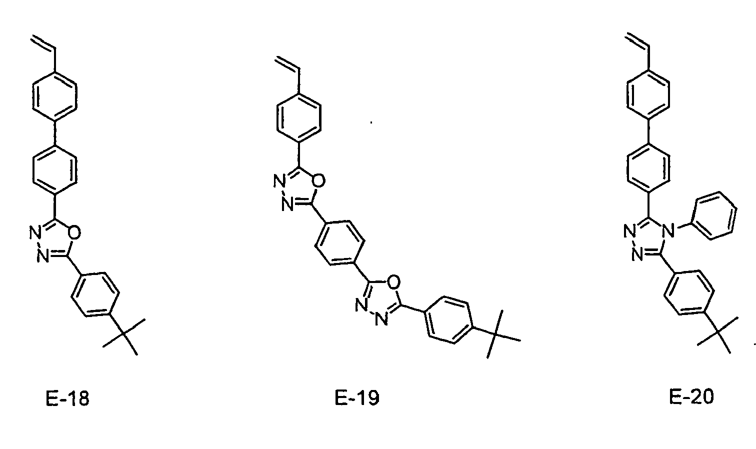

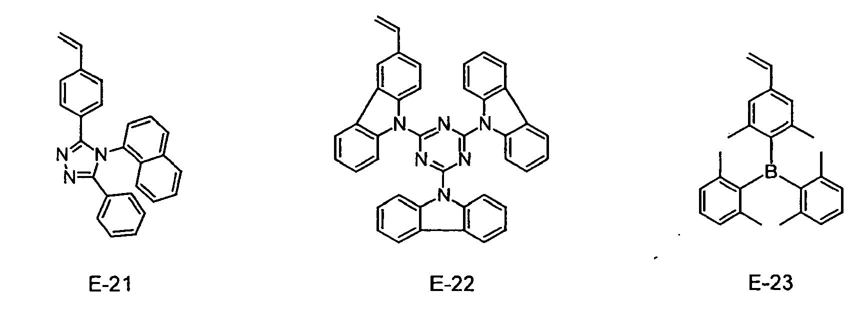

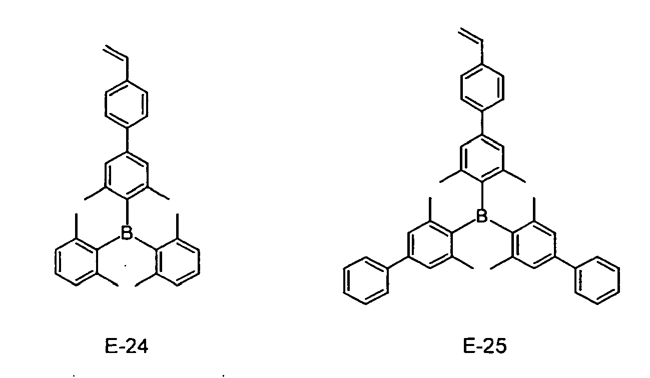

9. The polymer light-emitting material as claimed in claim 9, which is obtained by copolymerizing three or more kinds of polymerizable compounds containing an iridium complex represented by formula (1), a hole-transporting compound represented by formula (4) and an electron-transporting compound represented by formula (5).

10. The polymer light-emitting material as claimed in claim 1, which is obtained by polymerizing a polymerizable iridium complex represented by formula (1).

11. An organic light-emitting element, comprising a pair of electrodes and one or multiple organic layers including a light-emitting layer using the polymer light-emitting material described in any one of claims 1 to 10 between the electrodes.

12. An area light source using the organic light-emitting device described in claim 11.

13. An image display device using the organic light-emitting device described in claim 11.

## Patentansprüche

1. Licht emittierendes Polymermaterial, das erhalten wird durch (Co) polymerisation einer oder mehrerer polymerisierbarer Verbindungen mit einem Substituenten, worin ein Rest einer polymerisierbaren Doppelbindung der Formel (2) : 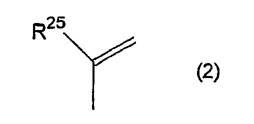 (worin R²⁵ ein Wasserstoffatom oder eine geradkettige Alkylgruppe mit 1 bis 5 Kohlenstoffatomen darstellt) an eines der Kohlenstoffatome eines aromatischen Rings gebunden ist, worin mindestens eine der polymerisierbaren Verbindungen ein Iridiumkomplex der Formel (1) ist: 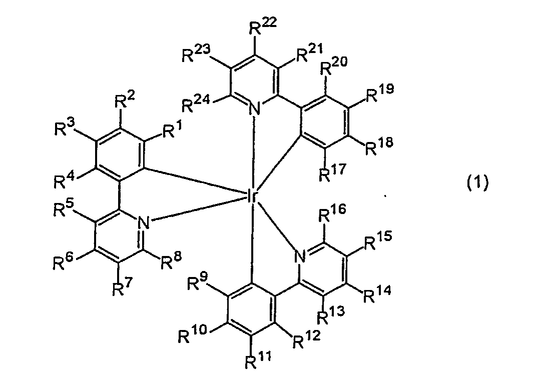 worin R bis R²⁴ jeweils unabhängig voneinander ein Wasserstoffatom, a Halogenatom, eine Cyangruppe, eine Alkylgruppe mit 1 bis 10 Kohlenstoffatomen, eine Arylgruppe mit 6 bis 10 Kohlenstoffatomen, eine Amingruppe, die mit einer Alkylgruppe mit 1 bis 10 Kohlenstoffatomen substituiert sein kann, eine Alkoxygruppe mit 1 bis 10 Kohlenstoffatomen oder eine Silylgruppe darstellen, mit der Maßgabe, dass einer der Substituenten R² bis R⁷ ein polymerisierbarer Substituent ist, der unter einem polymerisierbaren Doppelbindungsrest der Formel (2), einer aromatischen Ringgruppe, worin ein polymerisierbarer Doppelbindungsrest der Formel (2) an eines der Kohlenstoffatome des Rings gebunden ist, und einer Kohlenwasserstoffgruppe ausgewählt ist, die mit einer aromatischen Ringgruppe mit einem polymerisierbaren Doppelbindungsrest der Formel (2) substituiert ist und kein Heteroatom enthält.

2. Licht emittierendes Polymermaterial nach Anspruch 1, worin R¹, R⁴, R⁵, R⁸, R⁹, R¹², R¹³, R¹⁶, R¹⁷, R²⁰, R²¹ und R²⁴ in Formel (1) Wasserstoffatome sind.

3. Licht emittierendes Polymermaterial nach Anspruch 1, worin der polymerisierbare Substituent eine Vinylgruppe oder eine Gruppe der Formel (3) ist 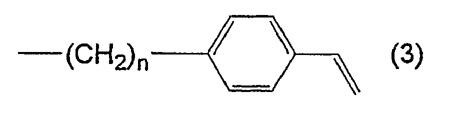 worin n 0 oder eine ganze Zahl von 1 bis 10 darstellt.

4. Licht emittierendes Polymermaterial nach Anspruch 1, das ein Polymer aus mindestens einer Trägertransportverbindung und einem polymerisierbaren Iridiumkomplex der Formel (1) ist, wobei die Trägertransportverbindung eine Lochtransportverbindung ist, ausgewählt unter

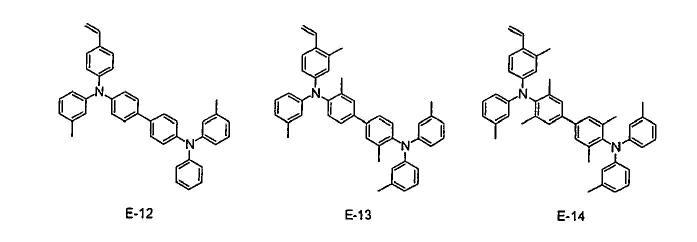

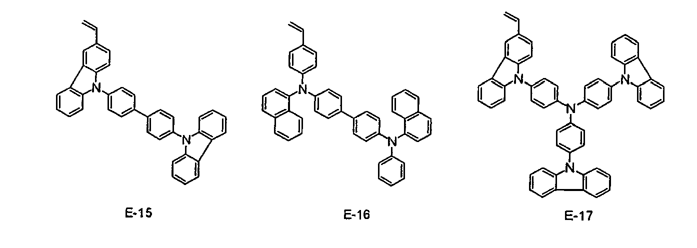

5. Licht emittierendes Polymermaterial nach Anspruch 1, das erhalten wird durch Copolymerisation von zwei oder mehr Arten von polymerisierbaren Verbindungen, die eine polymerisierbare Verbindung der Formel (4) und einen polymerisierbaren Iridiumkomplex der Formel (1) enthalten

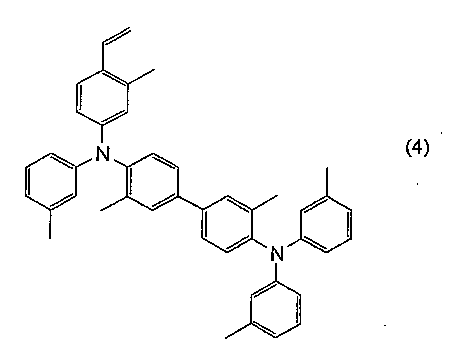

6. Licht emittierendes Polymermaterial nach Anspruch 1, das ein Polymermaterial aus mindestens einer Trägertransportverbindung und einem polymerisierbaren Iridiumkomplex der Formel (1) ist, wobei die
Trägertransportverbindung eine Elektronentransportverbindung ist, ausgewählt unter

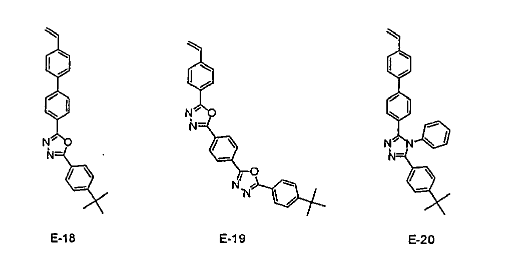

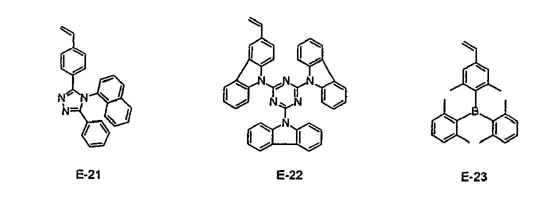

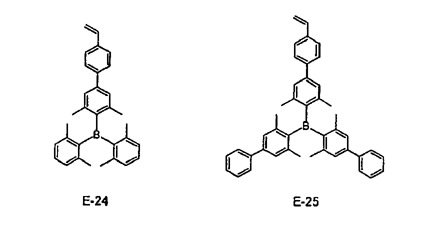

7. Licht emittierendes Polymermaterial nach Anspruch 1, das erhalten wird durch Copolymerisation von zwei oder mehr Arten von polymerisierbaren Verbindungen, die eine polymerisierbare Verbindung der Formel (5) und einen polymerisierbaren Iridiumkomplex der Formel (1) enthalten

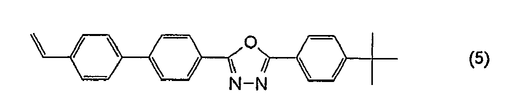

8. Licht emittierendes Polymermaterial nach Anspruch 1, das ein Copolymer aus polymerisierbaren Verbindungen, die einen Iridiumkomplex der Formel (1) enthalten, einer Lochtransportverbindung, ausgewählt unter 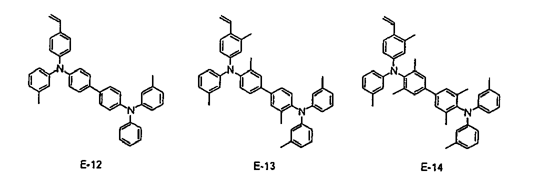 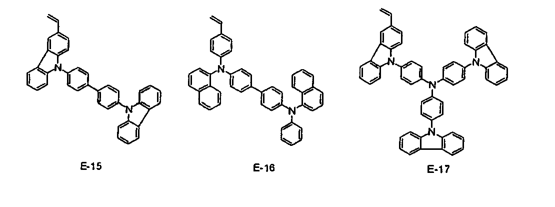 und einer Elektronentransportverbindung ist, ausgewählt unter

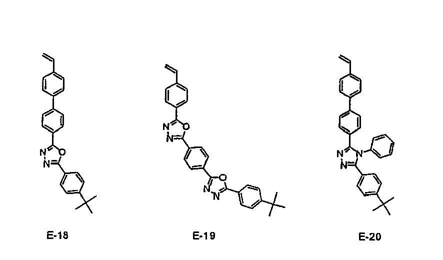

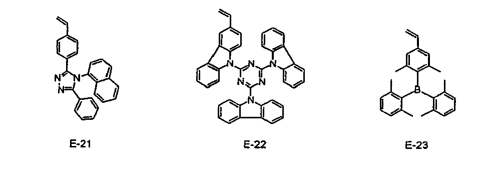

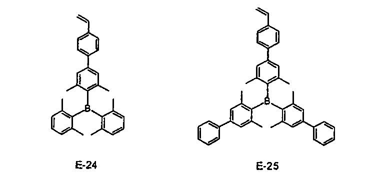

9. Licht emittierendes Polymermaterial nach Anspruch 9, das erhalten wird durch Copolymerisation von drei oder mehr Arten von polymerisierbaren Verbindungen, die einen Iridiumkomplex der Formel (1) enthalten, einer Lochtransportverbindung der Formel (4) und einer Elektronentransportverbindung der Formel (5).

10. Licht emittierendes Polymermaterial nach Anspruch 1, das erhalten wird durch Polymerisation eines polymerisierbaren Iridiumkomplexes der Formel (1).

11. Organisches Licht emittierendes Element, das ein Paar von Elektroden und eine oder mehrere organische Schichten, einschließlich eine Licht emittierende Schicht unter Verwendung des Licht emittierenden Polymermaterials nach einem der Ansprüche 1 bis 10 zwischen den Elektroden umfasst.

12. Flächenlichtquelle unter Verwendung der organischen Licht emittierenden Vorrichtung nach Anspruch 11.

13. Bildanzeigevorrichtung unter Verwendung der organischen Licht emittierenden Vorrichtung nach Anspruch 11.

## Revendications

1. Matériau polymère électroluminescent, qui est obtenu par (co)polymérisation d'un ou de plusieurs composés polymérisables portant un substituant, dans lequel un fragment double liaison polymérisable représenté par la formule (2) : 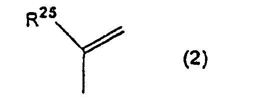 (dans laquelle R²⁵ représente un atome d'hydrogène ou un groupe alkyle à chaîne droite ayant de 1 à 5 atomes de carbone) est lié à l'un des atomes de carbone d'un cycle aromatique, au moins un des composés polymérisables étant un complexe d'iridium représenté par la formule (1): 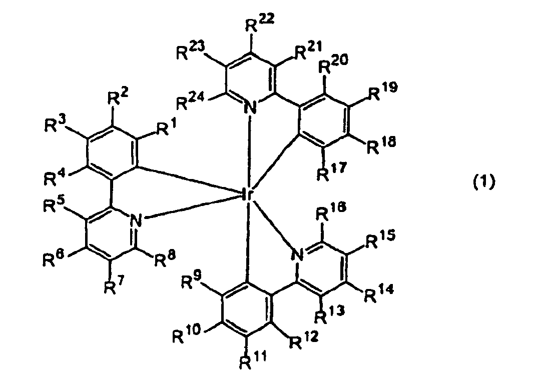 dans laquelle R¹ à R²⁴ représentent chacun indépendamment un atome d'hydrogène, un atome d'halogène, un groupe cyano, un groupe alkyle ayant de 1 à 10 atomes de carbone, un groupe aryle ayant de 6 à 10 atomes de carbone, un groupe amino qui peut être substitué par un groupe alkyle ayant de 1 à 10 atomes de carbone, un groupe alcoxy ayant de 1 à 10 atomes de carbone ou un groupe silyle, à condition que l'un des R² à R⁷ soit un substituant polymérisable choisi parmi un fragment double liaison polymérisable représenté par la formule (2), un groupe cycle aromatique dans lequel un fragment double liaison polymérisable représenté par la formule (2) est lié à l'un des atomes de carbone du cycle et un groupe hydrocarbure qui est substitué par le groupe cycle aromatique ayant un fragment double liaison polymérisable représenté pas la formule (2) et ne contenant pas d'hétéroatome.

2. Matériau polymère électroluminescent selon la revendication 1, dans lequel R¹, R⁴, R⁵, R⁸, R⁹, R¹², R¹³, R¹⁶, R¹⁷, R²⁰, R²¹ et R²⁴ dans la formule (1) sont des atomes d'hydrogène.

3. Matériau polymère électroluminescent selon la revendication 1, dans lequel le substituant polymérisable est un groupe vinyle ou un groupe représenté par la formule (3) 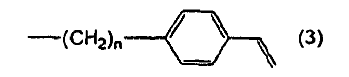 dans laquelle n représente 0 ou un nombre entier de 1 à 10.

4. Matériau polymère électroluminescent selon la revendication 1, qui est un copolymère d'au moins un composé transporteur de charges et d'un complexe d'iridium polymérisable représenté par la formule (1), dans lequel le composé transporteur de charges est un composé transporteur de trous choisi parmi

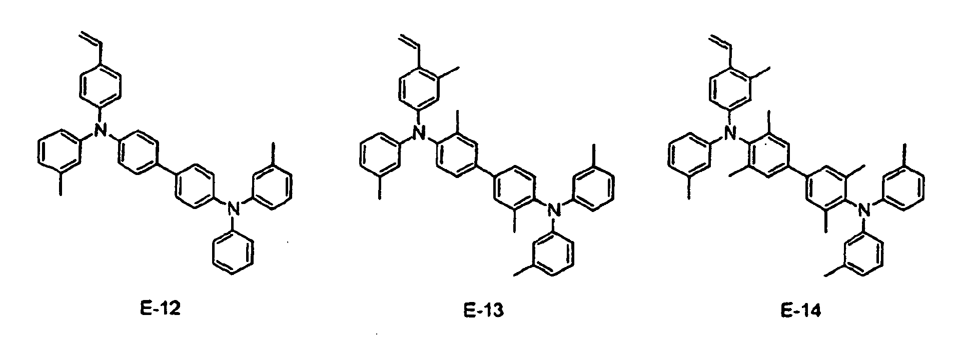

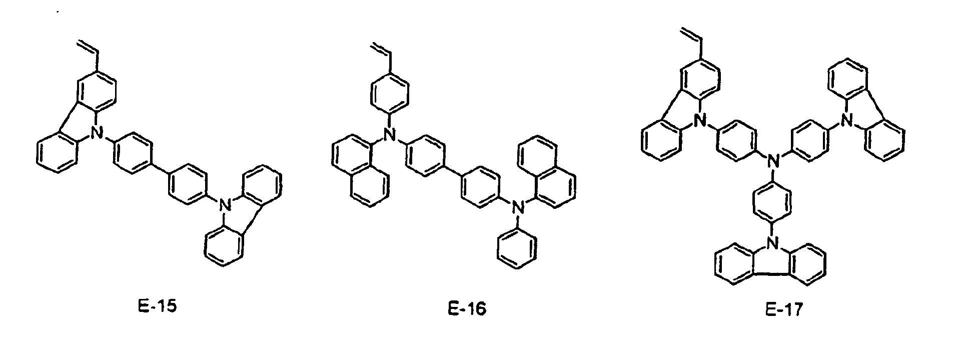

5. Matériau polymère électroluminescent selon la revendication 1, qui est obtenu par copolymérisation de deux types de composés polymérisables ou plus contenant un composé polymérisable représenté par la formule (4) et un complexe d'iridium polymérisable représenté par la formule (1).

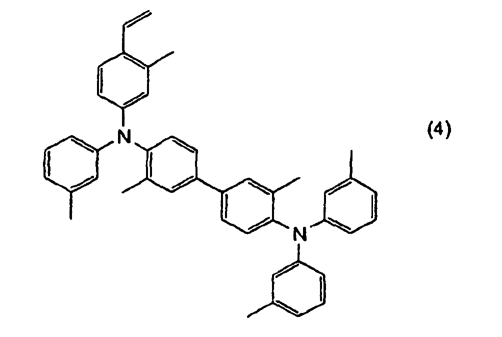

6. Matériau polymère électroluminescent selon la revendication 1, qui est un copolymère d'au moins un composé transporteur de charges et d'un complexe d'iridium polymérisable représenté par la formule (1), dans lequel le composé transporteur de charges est un composé transporteur d'électrons choisi parmi

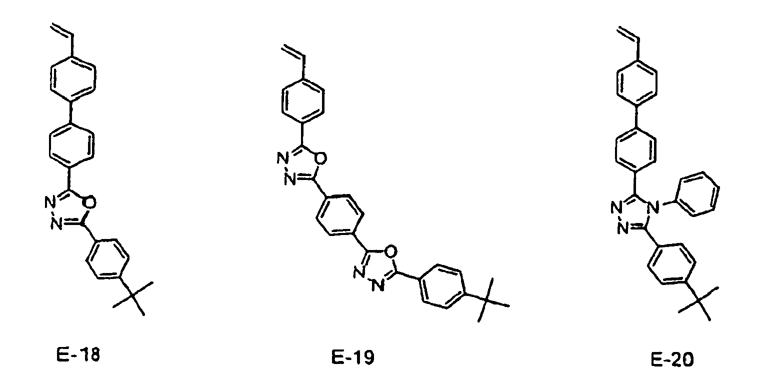

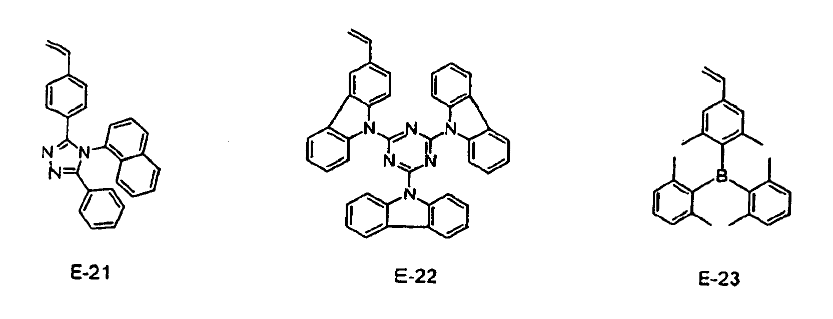

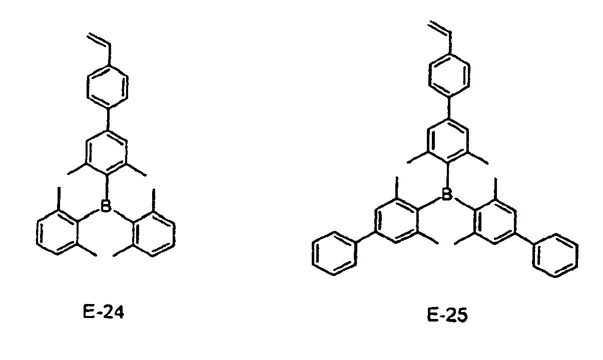

7. Matériau polymère électroluminescent selon la revendication 1, qui est obtenu par copolymérisation de deux types de composés polymérisables ou plus contenant un composé polymérisable représenté par la formule (5) et un complexe d'iridium polymérisable représenté par la formule (1).

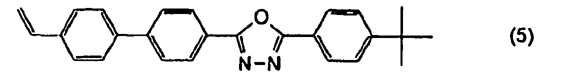

8. Matériau polymère électroluminescent selon la revendication 1, qui est un copolymère à base de composés polymérisables contenant un complexe d'iridium représenté par la formule (1), un composé transporteur de trous choisi parmi 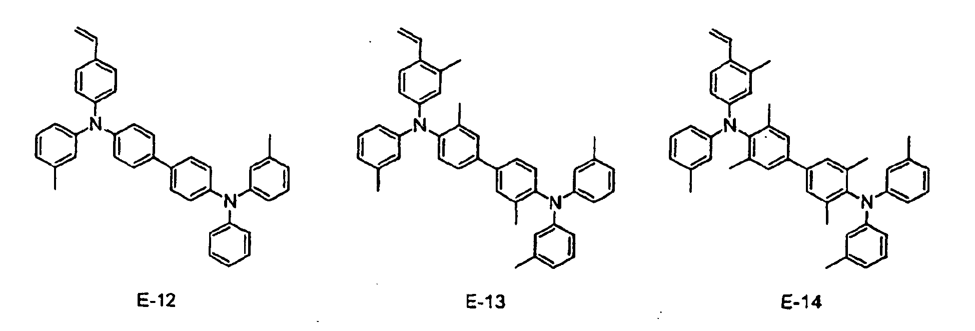 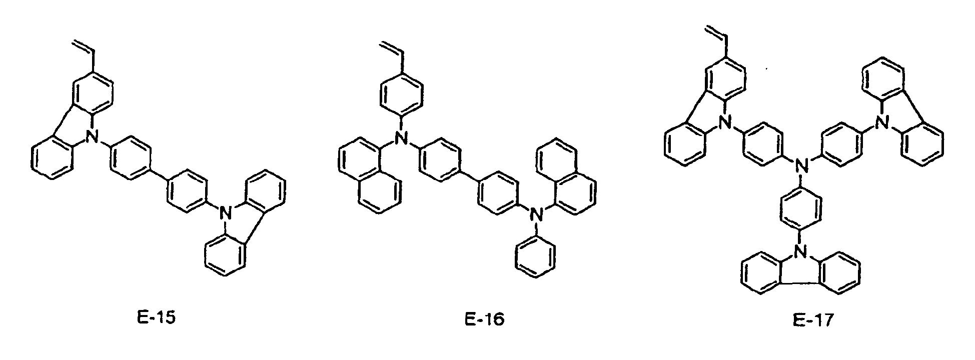 et un composé transporteur d'électrons choisi parmi

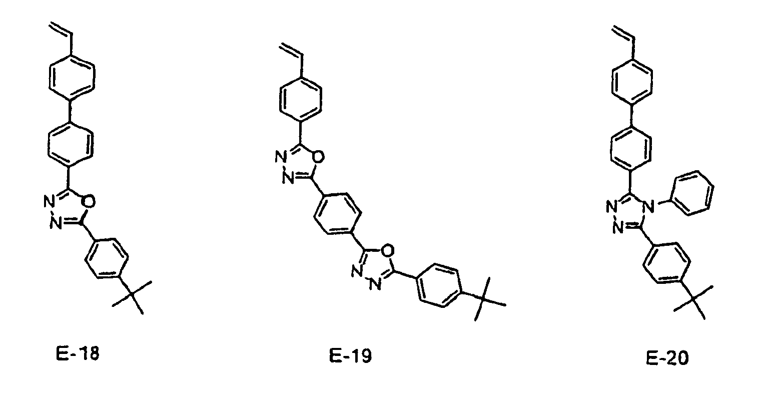

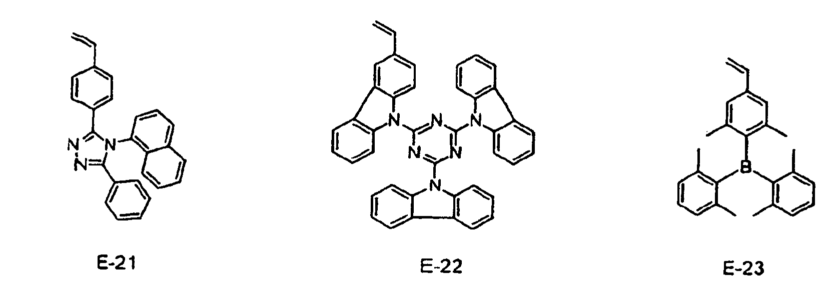

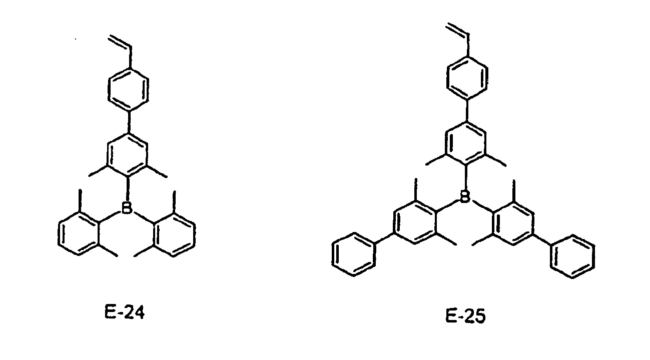

9. Matériau polymère électroluminescent selon la revendication 8, qui est obtenu par copolymérisation de trois types de composés polymérisables ou plus contenant un complexe d'iridium représenté par la formule (1), un composé transporteur de trous représenté par la formule (4) et un composé transporteur d'électrons représenté par la formule (5).

10. Matériau polymère électroluminescent selon la revendication 1, qui est obtenu par polymérisation d'un complexe d'iridium polymérisable représenté par la formule (1).

11. Elément électroluminescent organique, comprenant une paire d'électrodes et une ou plusieurs couches organiques comprenant une couche électroluminescente à base du matériau polymère électroluminescent décrit dans l'une quelconque des revendications 1 à 10 entre les électrodes.

12. Source d'aire lumineuse utilisant le dispositif électroluminescent organique selon la revendication 11.

13. Dispositif d'affichage d'image utilisant le dispositif électroluminescent organique selon la revendication 11.
